# EUROPÄISCHE PATENTSCHRIFT

(11) **EP 0 880 754 B1**
(45) Veröffentlichungstag und Bekanntmachung des Hinweises auf die Patenterteilung: **17.05.2000**
(21) Anmeldenummer: 97914139.7
(22) Anmeldetag: 12.02.1997
(51) Int. Cl.: G06K 19/077

(54) **VERFAHREN UND VORRICHTUNG ZUR KONTAKTIERUNG EINES DRAHTLEITERS**
METHOD AND DEVICE FOR BONDING A WIRE CONDUCTOR
PROCEDE ET DISPOSITIF POUR LA CONNEXION D'UN CONDUCTEUR ELECTRIQUE

(30) Priorität: 12.02.1996 DE 19604840; 17.05.1996 DE 19619771; 20.05.1996 DE 19620242
(43) Veröffentlichungstag der Anmeldung: 02.12.1998
(73) Patentinhaber: Finn, David, 87629 Füssen-Weissensee (DE); Rietzler, Manfred, 87616 Marktoberdorf (DE)
(72) Erfinder: Finn, David, 87629 Füssen-Weissensee (DE); Rietzler, Manfred, 87616 Marktoberdorf (DE)
(74) Vertreter: Böck, Bernhard, Dipl.-Ing.
(86) Internationale Anmeldenummer: DE9700261
(87) Internationale Veröffentlichungsnummer: WO9730418

(56) Entgegenhaltungen:
- EP-A- 0 535 433
- EP-A- 0 689 164
- DE-A- 4 325 334
- DE-A- 4 408 124
- DE-A- 4 410 732
- FR-A- 2 555 007
- GB-A- 624 369
- US-A- 5 025 550
- US-A- 5 186 378

## Beschreibung

Die vorliegende Erfindung betrifft ein Verfahren gemäß dem Oberbegriff des Anspruchs 1 sowie eine Vorrichtung zur Durchführung des Verfahrens mit den Merkmalen der Ansprüche 29 oder 34.

Insbesondere bei der Herstellung von auf einem Substrat angeordneten Transpondereinheiten, die als wesentliche Elemente eine Drahtspule und eine mit den Spulenenden kontaktierte Chipeinheit aufweisen, erweist sich die Kontaktierung der Spulenenden mit den Anschlußflächen der Chipeinheit als besonderes Problem. Im wesentlichen liegt dies in den sehr kleinen Abmessungen der miteinander zu verbindenden Komponenten begründet. So weisen die in der Regel quadratisch oder annähernd quadratisch ausgebildeten Anschlußflächen einer Chipeinheit standardmäßig eine Kantenlänge von ca. 100 bis 150µm auf. Als Spulendraht wird insbesondere zur Ausbildung von Niederfrequenzspulen ein Kupferdraht verwendet, dessen Durchmesser in der Regel bei 50 µm liegt.

Wie etwa aus der WO 91/16718 zu ersehen ist, wurde in der Vergangenheit eine direkte Kontaktierung der Spulendrahtenden mit den Anschlußflächen einer Chipeinheit dadurch umgangen, daß als Kopplungselement zwischen den Spulendrahtenden einer auf einem Spulensubstrat angeordneten Drahtspule und den Anschlußflächen der Chipeinheit ein vergrößerte Anschlußflächen aufweisendes Kontaktsubstrat verwendet wurde, so daß aufgrund der im Vergleich zum Spulendrahtdurchmesser sehr groß bemessenen Kontaktflächen des Kontaktsubstrats eine Kontaktierung ohne große Anforderung an die Genauigkeit der Relativpositionierung zwischen den Spulendrahtenden und den Kontaktflächen erfolgen konnte. Da bei dem bekannten Verfahren die Chipeinheit zur Kontaktierung mit den vergrößerten Anschlußflächen des Substrats mit zusätzlichen Kontaktleitern versehen ist, sind bei dem aus der WO 91/16718 bekannten Herstellungsverfahren insgesamt mindestens drei Kontaktierungsschritte erforderlich, um schließlich einen elektrisch leitenden Kontakt zwischen den Anschlußflächen der Chipeinheit und der Drahtspule herzustellen.

Aus der DE-A-44 10 732 ist ein Verfahren bekannt, bei dem die Ausbildung und Fixierung der Spule sowie die Verbindung von Spulendrähten mit Anschlußflächen eines Chips ineinander übergehend erfolgt. Bei dem bekannten Verfahren wird hierzu der Chip von der Kontaktierung mit den Spulendrähten auf dem Spulensubstrat angeordnet.

Der vorliegenden Erfindung liegt daher die Aufgabe zugrunde, ein Verfahren sowie eine Vorrichtung vorzuschlagen, die die unmittelbare Kontaktierung von Drahtenden auf den Anschlußflächen einer Chipeinheit ermöglicht

Diese Aufgabe wird durch ein Verfahren mit den Merkmalen des Anspruchs 1 bzw. eine Vorrichtung mit den Merkmalen der Ansprüche 29 oder 34 gelöst.

Bei dem erfindungsgemäßen Verfahren wird bei der Herstellung einer auf einem Substrat angeordneten, eine Drahtspule und eine Chipeinheit aufweisenden Transpondereinheit in einem ersten Verfahrensschritt der Spulendraht über die zugeordnete Anschlußfläche der Chipeinheit bzw. einen zur Aufnahme dieser Anschlußfläche bestimmten Raum geführt und auf dem Substrat fixiert. Hierdurch ist nach Ausführung des ersten Verfahrensschritts eine exakt definierte Ausrichtung des Spulendrahts relativ zur Anschlußfläche gegeben. Im zweiten Verfahrensschritt erfolgt dann die Verbindung des Drahtleiters mit der Anschlußfläche mittels einer Verbindungseinrichtung.

Aufgrund des erfindungsgemäßen Verfahrens entfällt die Notwendigkeit zur Kontaktierung der Anschlußflächen der Chipeinheit mit den Spulenenden ein gesondertes Kontaktsubstrat, auf dem vergrößerte Anschlußflächen ausgebildet sind, vorzusehen. Vielmehr dient quasi als Kontaktierungs- oder Positionierungshilfe zur Relativpositionierung der Spulenenden gegenüber den Anschlußflächen der Chipeinheit das ohnehin als Substrat für die Drahtspule verwendete Spulensubstrat, das beispielsweise in dem Fall, daß die Transpondereinheit zur Herstellung einer Chipkarte dienen soll, durch einen den Chipkartenabmessungen entsprechenden Kunststoffträgerbogen gebildet ist. Dabei kann die Chipeinheit sowohl in einer hierfür vorgesehenen Ausnehmung des Substrats angeordnet sein, als auch auf der Oberfläche des Substrats vorgesehen sein. Die erste Alternative bildet die Möglichkeit, die Chipeinheit wahlweise bereits vor Fixierung der Drahtleiter in der Ausnehmung anzuordnen, oder auch die Chipeinheit erst nach erfolgter Fixierung der Drahtleiter in die Ausnehmung einzuführen, um anschließend die eigentliche Kontaktierung der Drahtleiter auf den Anschlußflächen durchzuführen.

Das erfindungsgemäße Verfahren ermöglicht somit aufgrund der auf dem Spulensubstrat fixierten Drahtleiter eine vereinfachte Kontaktierung der Drahtleiter mit den Anschlußflächen der Chipeinheit.

Vorteilhafte Ausführungsformen des Verfahrens sind Gegenstand der Ansprüche 2 und 3.

Bei einer Variante des Verfahrens, die auch unabhängig vom Verfahren gemäß dem Anspruch 1 zur Kontaktierung einer Anschlußfläche mit einem Drahtleiter eine vorteilhafte Anordnung des Drahtleiters auf demSubstrat ermöglicht, wird der Drahtleiter in einer Richtung quer zur Verlegeebene mit Ultraschall beaufschlagt, und die durch die Ultraschallbeaufschlagung induzierte Querbewegung der Verlegevorrichtung wird der in der Verlegeebene verlaufenden Verlegebewegung überlagert.

Die Überlagerung der Verlegebewegung mit der den Drahtleiterquerschnitt in der Substratoberfläche versenkenden oder an diese anschmiegenden Querbewegung ermöglicht einen kontinuierlichen Betrieb der Verlegevorrichtung, so daß der Drahtleiter nicht nur im Bereich bestimmter Verbindungsstellen, sondern über eine beliebige Länge mit der Substratoberfläche verbindbar ist, ohne daß dabei mit der eigentlichen Verlegebewegung ausgesetzt werden müßte. Darüber hinaus erweist sich die ultraschallinduzierte Querbewegung als besonders effektiv bei der zumindest teilweisen Versenkung oder dem Anschmiegen des Drahtquerschnitts r da die durch den Ultraschall induzierte Bewegung in Absenkrichtung verläuft und nicht quer dazu, wie es bei dem eingangs beschriebenen Verfahren der Fall ist.

Als besonders vorteilhaft erweist es sich, wenn die durch Ultraschall induzierte Querbewegung längs einer im Winkel zur Achse der Verlegebewegung veränderbaren Querbewegungsachse erfolgt. Hierdurch ist es möglich, die Querbewegungsachse den speziellen Erfordernissen entsprechend einzustellen. So ist es möglich, für den Fall, daß etwa in Abhängigkeit von dem Substratmaterial eine erhöhte Temperatur des zu versenkenden Drahtleiters gewünscht wird, die Querbewegungsachse mehr in Richtung der Verlegebewegungsachse auszurichten, um so eine größere auf den Drahtleiter wirkende Längskraftkomponente zu erhalten, die durch das damit verbundene Reiben des Drahtführers am Drahtleiter zu einer Erwärmung desselben führt. Um eine möglichst große Absenkrate des Drahtleiters in der Substratoberfläche zu erreichen, kann es vorteilhaft sein, die Querbewegungsachse unter einem Winkel von 45° zur Verlegebewegungsachse auszurichten, um einen größtmöglichen Schubeffekt im Substratmaterial zu erzielen.

Um die Eindringtiefe des Drahtleiters in die Substratoberfläche zu verändern, kann auch die Ultraschallfrequenz und/oder der Winkel zwischen der Achse der Verlegebewegung und der Querbewegungsachse verändert werden.

Als besonders vorteilhaft im Hinblick auf ein der Verlegung des Drahtleiters als Drahtspule auf der Substratoberfläche nachfolgendes Verbindungeverfahren zur Verbindung des Drahtleiters mit Anschlußflächen einer Chipeinheit kann es sich erweisen, wenn der Spulenendbereich und der Spulenanfangsbereich über eine Ausnehmung des Substrats hinweggeführt werden, so daß die nachfolgende Verbindung der Anschlußflächen einer Chipeinheit mit dem Spulenanfangsbereich und dem Spulenendbereich ohne Beeinträchtigung durch das Substratmaterial erfolgen kann.

Um eine möglichst gradlinige Ausrichtung des Spulenanfangsbereichs und des Spulenendbereichs zwischen gegenüberliegenden Ausnehmungsrändern der Ausnehmung zu ermöglichen' ist es vorteilhaft, die Ultraschallbeaufschlagung des Drahtleiters im Bereich der Ausnehmung auszusetzen.

Ein Aussetzen der Ultraschallbeaufschlagung des Drahtleiters erweist sich auch, zur Überquerung eines bereits verlegten Drahtabschnitts im Überquerungsbereich, als vorteilhaft, wobei zusätzlich der Drahtleiter im Überquerungsbereich in einer gegenüber der Verlegeebene beabstandeten Überquerungsebene geführt wird. Hierdurch wird erreicht, daß eine Kreuzung von Drahtleitern möglich wird, ohne daß dabei Beschädigungen durch Aneinanderstoßen der Drahtleiter, die etwa zu einer Zerstörung der Drahtleiterisolation führen könnten, auftreten können.

Als besonders vorteilhaft hat sich auch die Anwendung des vorstehend in verschiedenen Ausführungsformen beschriebenen Verfahrens zur Herstellung eines Kartenmoduls mit einem Substrat, einer auf dem Substrat verlegten Spule und einer mit der Spule verbundenen Chipeinheit erwiesen. Dabei wird in einer Verlegephase mittels der Verlegevorrichtung eine spule mit einem Spulenanfangsbereich und einem Spulenendbereich auf dem Substrat ausgebildet und in einer nachfolgenden Verbindungsphase mittels einer Verbindungsvorrichtung eine Verbindung zwischen dem Spulenanfangsbereich und dem Spulenendbereich mit Anschlußflächen der Chipeinheit durchgeführt.

Diese Anwendung des Verfahrens ermöglicht durch die Integration der Verlegung des Drahtleiters auf dem Substrat in ein Verfahren zur Herstellung eines Kartenmoduls ausgehend von einem beliebigen Substrat, das ein zumindest teilweises Eindringen des Drahtleiters in oder Anschmiegen des Drahtleiters an die Substratoberfläche zuläßt, die Ausbildung leicht handhabbarer Kartenmodule, die als Halbzeug bei der Chipkartenherstellung Verwendung finden. Zur Fertigstellung der Chipkarte werden dann die Kartenmodule in der Regel beidseitig mit Decklaminatschichten versehen. Je nach Ausbildung und Dicke des Substratmaterials kann die Verbindung zwischen dem Drahtleiter und dem Substratmaterial über einen mehr oder weniger formschlüssigen Einschluß des Drahtleiterquerschnitts in die Substratoberfläche - etwa bei Ausbildung des Substrats aus einem thermoplastischen Material - oder durch ein überwiegendes! anschmiegendes Fixieren des Drahtleiters auf der Substratobeflache, etwa durch Verkleben des Drahtleiters mit der Substratoberfläche, erfolgen Letzteres wird zum Beispiel dann der Fall sein, wenn es sich bei dem Substratmaterial um einen vliesartigen oder gewebeartigen Träger handelt.

Insbesondere bei der Herstellung von Papier- oder Kartenbandagen, wie sie beispielsweise zur Gepäckidentifikation verwendet werden, hat sich die Verbindung des Drahtleiters mit der Substratoberfläche über eine Kleberschicht zwischen dem Drahtleiter und der Substratoberfläche als vorteilhaft erwiesen. Dabei schmiegt sich der Drahtleiter in einem Umfangsbereich über die Kleberschicht an die Substratoberfläche an. Wenn der Drahtleiter mit einer geeigneten Oberflächenbeschichtung versehen ist, beispielsweise Backlack, kann die Kleberschicht aus der Oberflächenbeschichtung gebildet sein.

Als besonders effektiv bei der vorstehenden Verfahrensapplikation hat sich die Anwendung eines Thermokompressionsverfahrens zur Verbindung des Spulenanfangsbereichs und des Spulenendbereichs mit den Anschlußflächen der Chipeinheit herausgestellt.

Eine weitere Steigerung der Effektivität der vorstehenden Verfahrensapplikation läßt sich erreichen, wenn gleichzeitig die Herstellung einer Mehrzahl von Kartenmodulen erfolgt, derart, daß in einer Zuführphase einer eine Mehrzahl von Verlegevorrichtungen und Verbindungsvorrichtungen aufweisenden Kartenmodulproduktionsvorrichtung eine Mehrzahl von in einem Nutzen Zusammengefaßt angeordneten Substraten zugeführt wird, und anschließend in der Verlegephase eine Mehrzahl von spulen gleichzeitig auf in einer Reihe angeordneten Substraten ausgebildet wird, anschließend in der Verbindungsphase eine Mehrzahl von Chipeinheiten über ihre Anschlußflächen mit den Spulen verbunden wird und schließlich in einer Vereinzelungsphase eine Vereinzelung der Kartenmodule aus dem Nutzenverbund erfolgt.

Des weiteren hat sich eine Verfahrensapplikation zur Herstellung einer rotationssymmetrischen Körperspule als vorteilhaft erwiesen, wobei der drahtförmige Leiter auf einem als Wicklungsträger ausgebildeten, relativ zur Verlegevorrichtung rotierenden Substrat verlegt wird. Zur Ausbildung der Relativrotation besteht die Möglichkeit, entweder bei stationärer Verlegevorrichtung das Substrat um seine längsachse in Rotation zu versetzen, oder bei stationärem Substrat die Verlegevorrichtung auf einer Bewegungsbahn um die Längsachse des Substrats zu bewegen, oder auch die beiden vorgenannten Bewegungsarten zu überlagern.

Die vorgenannte Verfahrensapplikation bietet sich insbesondere zur Herstellung einer einstückig mit einer Schwingmembran verbundenen Tauchspule einer Lautsprechereinheit an.

Gemäß einer weiteren Verfahrensapplikation dient das Verfahren! zur Verlegung eines drahtförmigen Leiters auf einem Substrat mittels einer mit Ultrasclall auf den Drahtleiter einwirkenden Verlegevorrichtung zur Herstellung eines Flachbandkabels wobei eine der Anzahl der gewünschten Kabelleiter entsprechende Anzahl von Verlegevorrichtungen quer zur Längsachse eines flachbandförmigen Substrats angeordnet ist und eine Relativbewegung zwischen dem Substrat und den Verlegevorrichtungen in Längsachsenrichtung des Substrats erfolgt.

Um eine zuverlässige und betriebssichere Kontaktierung zwischen dem Drahtleiter und den standardmäßig durch Aluminiumoberflächen gebildeten Anschlußflächen der Chipeinheit zu erzielen, ist es insbesondere bei Verwendung eines Kupferdrahtleiters vorteilhaft, die Aluminiumoberfläche der Anschlußflächen einer Vorbehandlung zu unterziehen. Bei einer besonders vorteilhaften Ausführungsform des erfindungsgemäßen Verfahrens wird die Vorbehandlung der Aluminiumoberfläche quasi in den eigentlichen Verbindungsvorgang, also die Kontaktierung des Drahtleiters mit den Anschlußflächen, integriert, dadurch, daß die Verbindung des Drahtleiters mit den Anschlußflächen mittels einer als Ultraschalleinrichtung ausgebildeten Verbindungseinrichtung erfolgt. Hierbei wird eine auf der Aluminiumoberfläche angeordnete Oxidschicht durch Beaufschlagung der Oxidschicht mit den Ultraschallschwingungen der Ultraschalleinrichtung mechanisch beseitigt. Diese Art der im wesentlichen zeitgleich mit dem eigentlichen Verbindungsvorgang erfolgenden Reinigung der Aluminiumoberflächen von der Oxidschicht weist den besonderen Vorteil auf, daß auf besondere Maßnahmen hinsichtlich einer Abschirmung der Verbindungsstellen vor Umgebungseinflüssen, beispielsweise durch Ausbildung einer inerten oder reduzierenden Atmosphäre, die die Ausbildung einer erneuten Oxidschicht vor Durchführung des Verbindungsvorgangs verhindern sollen, verzichtet werden kann.

Wird hingegen als Alternative zu der vorgenannten ultraschallinduzierten Entfernung der Oxidschicht in Verbindung mit einem Ultraschallverbindungsvorgang ein vom eigentlichen Verbindungsvorgang entkoppeltes Vorbehandlungs- oder Reinigungsverfahren gewählt, kann der Verbindungsvorgang selbst in einer inerten oder reduzierenden Atmosphäre durchgeführt werden.

Als besonders vorteilhaft zur Reinigung der Aluminiumoberflächen der Anschlußflächen von Oxidschichten erweist sich der Einsatz von Ätzverfahren, die eine große Selektivität aufweisen. Ein Beispiel für Trockenätzverfahren ist das Ionenstrahlenätzen. Aber auch die Verwendung von einfach durchführbaren Verfahren, wie das Naßätzen oder ein Oxidschichtabtrag durch Laser -, insbesondere Excimerlaser-Beaufschlagung, ist vorteilhaft.

Zur Verhinderung einer erneuten Oxidierung der Aluminiumoberfläche besteht auch die Möglichkeit, die Aluminiumoberfläche mit einer mehrschichtigen Kontaktmetallisierung mit einer auf die Aluminiumoberfläche als Zwischenschicht aufgebrachten Zinkatschicht und einer darauf angeordneten, für die Kontaktierung mit dem Drahtleiter vorgesehenen Verbindungsschicht zu versehen. Dabei dient die Zinkatschicht in erster Linie dazu, die Oxidschicht auf der Aluminiumoberfläche zu beseitigen, und die Verbindungsschicht, die etwa aus Nickel oder Palladium oder entsprechenden Legierungen bestehen kann, zur Verbesserung der Haftung zu den in der Regel als Drahtleiter verwendeten Kupferdrähten.

Im Fall der Verwendung einer Ultraschalleinrichtung zur Herstellung der Verbindung zwischen dem Drahtleiter und den Anschlußflächen erweist es sich als besonders vorteilhaft, wenn die durch Ultraschall bewirkte Schwingungsbeaufschlagung des Drahtleiters in einer im wesentlichen zur Anschlußfläche parallelen Ebene und quer, etwa rechtwinklig, zur Längsachse des Drahtleiters erfolgt. Mittels der quer zur Drahtlängsachse erfolgenden Ultraschallbeaufschlagung des Drahtleiters lassen sich nämlich aufgrund der Querflexibilität des in Längsrichtung beidseitig der Anschlußfläche auf dem Substrat fixierten Drahtleiters die größtmöglichen Relativbewegungen zwischen dem Drahtleiter und der Aluminiumoberfläche erzielen.

Unabhängig von der Art und Weise der Vorbehandlung sowie der Wahl des Verbindungsverfahrens ist es von besonderem Vorteil, wenn als Spulensubstrat ein Kunststoffträgerbogen verwendet wird, der zusammen mit der Spule und der Chipeinheit ein Karteninlet zur Herstellung einer Kreditkarte oder dergleichen bildet. Alternativ sind auch hiervon abweichende Spulenträgerausbildungen möglich, die lediglich in jedem Fall, also unabhängig von der jeweiligen Ausbildung, eine sichere beidseitige Fixierung des Drahtleiters relativ zu den Anschlußflächen der Chipeinheit ermöglichen müssen. Hierdurch wird auch eine quasi hängende Anordnung und damit eine "schwimmende Aufnahme" des Chips im Substrat möglich. So ist beispielsweise auch die Verwendung eines Papierbogens als Spulensubstrat möglich, wobei die Fixierung des Drahtleiters auf dem Substrat über eine auf dem Papierbogen vorgesehene, am Drahtleiter haftende Adhäsionsschicht oder auch eine am Drahtleiter selbst vorgesehene Adhäsionsschicht, etwa eine Backlack-Schicht, erfolgen kann.

Unabhängig von der Art des verwendeten Spulensubstrats erweist es sich als vorteilhaft, wenn die Fixierung des Drahtleiters auf dem Substrat durch eine ohnehin zur spulenförmigen Anordnung des Drahtleiters auf dem Substrat eingesetzte Verlegeeinrichtung erfolgt, die eine kontinuierliche oder stellenweise Verbindung des Drahtleiters mit der Substratoberfläche ermöglicht. Dabei erweist es sich insbesondere bei Verwendung von Kunststoffsubstraten als vorteilhaft, wenn als Verlegeeinrichtung eine Ultraschalleinrichtung eingesetzt wird, die eine zumindest teilweise Einbettung des Drahtleiterquerschnitts in die Substratoberfläche und damit eine Fixierung mit guter Haftung ermöglicht.

Eine besonders gute Fixierung des Drahtleiters an der Substratoberfläche und die Herstellung einer besonders zuverlässigen Verbindung des Drahtleiters mit den Anschlußflächen der Chipeinheit ist möglich, wenn die zur Verlegung und Fixierung des Drahtleiters auf dem Substrat verwendete Ultraschalleinrichtung eine Schwingungsbeaufschlagung des Drahtleiters quer zur Längsachse des Drahtleiters und quer zur Oberfläche des Substrats bewirkt, und die zur Verbindung des Drahtleiters mit den Anschlußflächen verwendete Ultraschalleinrichtung eine Schwingungsbeaufschlagung des Drahtleiters in einer im wesentlichen zum Substrat parallelen Ebene und quer zur Längsachse des Drahtleiters bewirkt.

Die Verlegevorrichtung zur Verlegung eines drahtförmigen Leiters auf einem Substrat mittels Ultraschall weist einen Drahtführer und einen Ultraschallgeber auf, wobei der Ultraschallgeber derart mit dem Drahtführer verbunden ist, daß der Drahtführer zur Ausführung von Ultraschallschwingungen in Längsachsenrichtung angeregt wird.

Vorteilhaft ist, wenn die zur Durchführung des erfindungsgemäßen Verfahrens geeignete Vorrichtung eine Ultraschalleinrichtung mit einem den Drahtquerschnitt teilweise umfassenden Schwingungsstempel mit einem Ultraschalloszillator aufweist, der eine Schwingungsbeaufschlagung des Schwingungsstempels quer zur Längsachse eines durch den Schwingungsstempel geführten Drahtleiters aufweist.

Gemäß einer bevorzugten Ausführungsform der Vorrichtung ist die Ultraschalleinrichtung mit einer Drahtverlegeeinrichtung gekoppelt.

Eine besonders einfache Ausbildung der Vorrichtung wird möglich, wenn der Ultraschalloszillator der Ultraschalleinrichtung gleichzeitig zur Ultraschallbeaufschlagung der Verlegeeinrichtung dient, etwa dadurch, daß der Ultraschalloszillator derart angeordnet ist, daß die Achse seiner Wirkrichtung veränderbar ist.

Gemäß einer alternativen Lösung weist die Verlegevorrichtung die Merkmale des Anspruchs 34 auf. Eine vorteilhafte Ausführungsform weist die Merkmale des Anspruchs 35 auf.

Als vorteilhaft für die Ausführung der Verlegevorrichtung erweist es sich, wenn diese mit einer Drahtführungskapillare versehen ist, die zumindest im Bereich eines Drahtführermundstücks längsachsenparallel im Drahtführer verläuft. Auf diese Art und weise ist sichergestellt, daß im Bereich des Drahtführermundstücks die axiale Vorschubbewegung des Drahtleiters nicht von ultraschallinduzierte Querbelastungen beeinträchtigt wird Vielmehr verläuft die Ultraschallbeaufschlagung in Drahtlängsrichtung.

Zur Einführung des Drahtleiters in den Drahtführer erweist es sich jedoch als vorteilhaft, wenn der Drahtführer beabstandet zum Drahtführermundstück mindestens einen schräg zur Drahtlängsachse verlaufenden Drahtzuführkanal aufweist.

Zur Vermeidung von ultraschallinduzierten Querbelastungen des Drahtleiters im Drahtführermundstückbereich trägt es auch bei wenn der Ultraschallgeber koaxial zum Drahtführer angeordnet ist.

Nachfolgend werden das erfindungsgemäße Verfahren und zur Durchführung des Verfahrens geeignete Vorrichtungen anhand der Zeichnungen beispielhaft erläutert. Es zeigen:
- **Fig. 1**: eine schematische Darstellung der Verlegung eines Drahtleiters auf einem Substrat mittels Ultraschall;
- **Fig. 2**: eine Elektronenmikroskopaufnahme zur Darstellung eines in das Substrat eingebetteten Drahtleiters;
- **Fig. 3**: eine Verlegevorrichtung zur Verlegung eines Drahtleiters mittels Ultraschall;
- **Fig. 4**: ein in Spulenform auf einem Substrat verlegter Drahtleiter mit über eine Ausnehmung im Drahtleiter hinweggeführten Enden;
- **Fig. 5**: eine gegenüber **Fig. 4** variierte Spulenkonfiguration mit über eine Substratausnehmung hinweggeführten Drahtenden;
- **Fig. 6**: die Plazierung einer Chipeinheit in der in **Fig. 5** dargestellten Substratausnehmung;
- **Fig. 7**: die Verbindung der in **Fig. 5** dargestellten Drahtenden mit Anschlußflächen der in die Ausnehmung eingesetzten Chipeinheit;
- **Fig. 8**: eine Produktionsvorrichtung zur Herstellung von Kartenmodulen;
- **Fig. 9**: die Verlegung eines Drahtleiters mittels Ultraschall auf einem rotationssymmetrischen Wickelkörper;
- **Fig. 10**: eine durch Ultraschallverlegung auf einem zylindrischen Wickelkörper hergestellte Tauchspule einer Lautsprechereinheit;
- **Fig. 11**: eine Längsabschnittsdarstellung eines mit Drahtleitern versehenen Flachbandkabels;
- **Fig. 12**: eine weitere Verlegevorrichtung zur Verlegung eines Drahtleiters mittels Ultraschall.

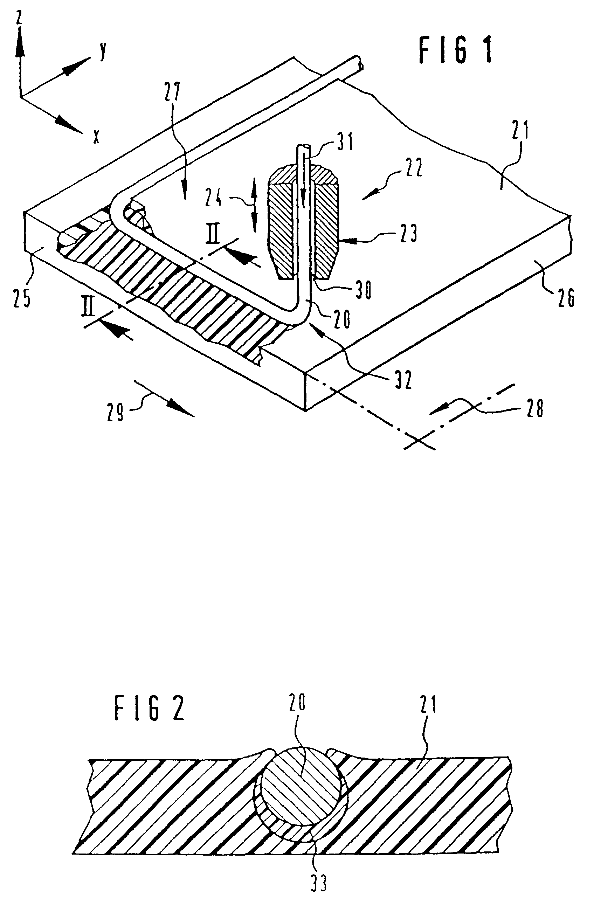

**Fig. 1** zeigt in einer schematischen Darstellung die Verlegung eines Drahtleiters 20 auf einem Substrat 21 mittels einer durch Ultraschall beaufschlagten Verlegevorrichtung 22 mit einem Drahtführer 23.

Die in **Fig. 1** dargestellte Verlegevorrichtung 22 ist dreiachsig verfahrbar ausgebildet und wird mit Ultraschall beaufschlagt, der den Drahtführer 23 zu oszillierenden Querbewegungen (Pfeil 24) anregt, die in dem in **Fig. 1** dargestellten Beispiel senkrecht zu einer durch Seitenkanten 25, 26 einer Substratoberfläche 27 aufgespannten Verlegeebene 28 ausgerichtet sind.

Zur Verlegung wird der Drahtleiter 20 unter Ausführung einer kontinuierlichen Vorschubbewegung in Richtung des Pfeils 29 aus einem Drahtführermundstück 30 hinausbewegt, wobei gleichzeitig der Drahtführer 23 eine parallel zur Verlegeebene 28 verlaufende Verlegebewegung 29 ausführt, die in **Fig. 1** am Verlauf des bereits auf dem Substrat 21 verlegten Drahtleiterabschnitts nachvollzogen werden kann. Dieser Verlegebewegung die im Bereich der vorderen Seitenkante 25 in Richtung des Pfeils 29 verläuft, wird die oszillierende Querbewegung 24 überlagert. Hieraus resultiert ein entsprechend der ultraschallfrequenz in schneller Folge wiederholtes Auftreffen oder -schlagen des Drahtführermundstücks 30 auf den Drahtleiter 20, was zu einer Verdichtung und/oder Verdrängung des Substratmaterials im Bereich einer Kontaktstelle 32 führt.

**Fig. 2** zeigt in einer Schnittdarstellung, die in etwa dem in **Fig. 1** angedeuteten Schnittlinienverlauf II-II entspricht, die eingebettete Anordnung des Drahtleiters 20 im Substrat 21. Bei dem hier dargestellten Substrat handelt es sich um eine PVC-Folie, wobei zur Einbettung des Drahtleiters 20 der Drahtleiter über die Verlegevorrichtung 22 beispielsweise mit einer Ultraschalleistung von 50 W und einer Ultraschallfrequenz von 40 KHz beaufschlagt wird. Die Anpreßkraft, mit der das Drahtführermundstück 30 gegen die Substratoberfläche 27 zur Anlage gebracht wird, kann bei dem vorgenannten Substratmaterial im Bereich zwischen 100 und 500 N liegen. Wie aus der Darstellung gemäß **Fig. 2** hervorgeht, wurde bei einem durchgeführten Versuch durch Einstellung der vorgenannten Parameter eine Einbettung des Drahtleiters 20 in das Substrat 21 im wesentlichen aufgrund einer Verdichtung des Substratmaterials in einem hier sichelmondförmig ausgebildeten Verdichtungsbereich 33 des Substratmaterials erreicht.

Das in **Fig. 1** dargestellte Verlegeprinzip läßt sich universell einsetzen So kann das Prinzip abweichend von der nachfolgend ausführlich erläuterten Verwendung bei der Herstellung eines

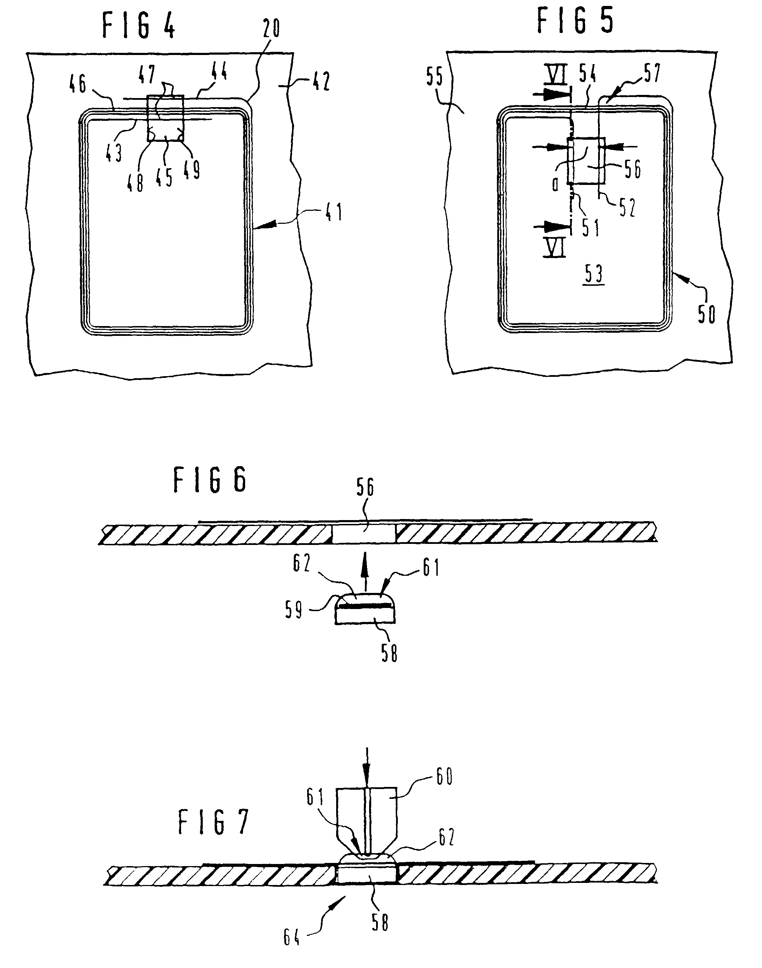

Kartenmoduls (**Fig. 4** bis **7**) auch Verwendung finden bei Verlegung von Drahtspulen in Kunststoffgehäusen, etwa zur Ausbildung einer Antenne für ein schnurloses Telefon (Handy), oder auch zur Ausbildung einer Meßspule eines Sensors.

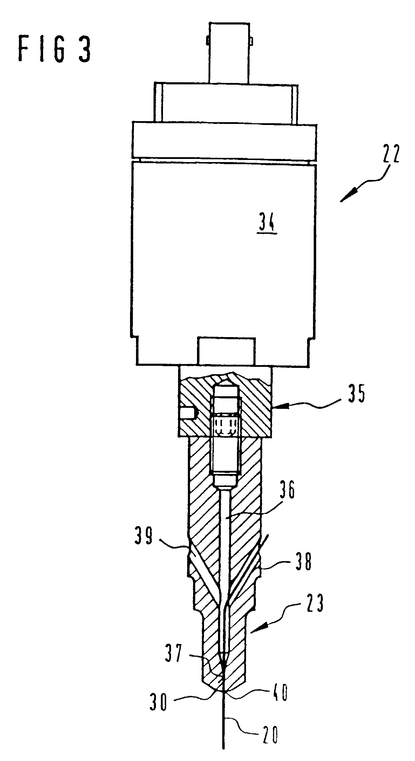

**Fig. 3** zeigt die Verlegevorrichtung 22 in einer Einzeldarstellung mit einem Ultraschallgeber 34, der koaxial zum Drahtführer 23 angeordnet und mit diesem in einem Verbindungsbereich 35 starr verbunden ist. Die in **Fig. 3** dargestellte Verlegevorrichtung 22 ist insgesamt rotationssymmetrisch ausgebildet. Der Drahtführer 23 weist eine zentrale Längsbohrung 36 auf, die im Bereich des Drahtführermundstücks 30 in eine Drahtkapillare 37 übergeht, die gegenüber der Längsbohrung 36 einen verengten, auf den Durchmesser des Drahtleiters 20 abgestimmten Durchmesser aufweist Die Drahtführungskapillare 37 dient in erster Linie dazu, den Drahtleiter in der Verlegeebene 28 (**Fig. 1**) exakt ausrichten zu können.

Seitlich am Drahtführer 23 sind bei dem in **Fig. 3** dargestellten Ausführungsbeispiel oberhalb des Drahtführermundstücks in die Längsbohrung 36 einmündend zwei Drahtzuführkanäle 38, 39 angeordnet, die in Richtung auf das Drahtführermundstück 30 schräg nach unten verlaufen Die Drahtzuführkanäle 38, 39 dienen zur seitlichen Einführung des Drahtleiters 20 in den Drahtführer 23, so daß der Drahtleiter 20, wie in Fig. 3 dargestellt, seitlich schräg in den Drahtzuführkanal 38, durch die Längsbohrung 36 hindurch und aus der Drahtführungskapillare 37 hinausgeführt durch den Drahtführer 23 hindurch verläuft. Dabei läßt die mehrfache Anordnung der Drahtzuführkanäle 38, 39 die Auswahl der jeweils günstigsten Drahtzuführungsseite am Drahtführer 23 zu.

Wie weiter aus **Fig. 3** hervorgeht, ist das Drahtführermundstück 30 im Bereich einer Drahtaustrittsöffnung 40 konvex ausgebildet, um eine für den Drahtleiter 20 möglichst schonende Umlenkung im Bereich der Kontaktstelle 32 (**Fig. 1** ) bzw. der Drahtaustrittsöffnung 40 bei dem in **Fig. 1** dargestellten Verlegevorgang zu ermöglichen.

Obwohl in **Fig. 3** nicht näher dargestellt, kann der Drahtführer 23 mit einer Drahtabtrenneinrichtung und einer Drahtvorschubeinrichtung versehen sein. Dabei kann die Drahtabtrennvorrichtung unmittelbar in das Drahtführermundstück 30 integriert sein. **Fig. 4** zeigt einen Drahtleiter 20, der zur Ausbildung einer in diesem Fall als Hochfrequenz-Spule ausgebildeten Spule 41 auf einem Substrat 42 verlegt ist. Die Spule 41 weist hier eine im wesentlichen rechteckförmige Konfiguration auf mit einem Spulenanfangsbereich 43 und einem Spulenendbereich 44, die über eine fensterförmige Substratausnehmung 45 hinweggeführt sind. Dabei befinden sich der Spulenanfangsbereich 43 und der Spulenendbereich 44 in paralleler Ausrichtung zu einem Spulenhauptstrang 46, den sie im Bereich der Substratausnehmung 45 zwischen sich aufnehmen. Bei der im Prinzip bereits unter Bezugnahme auf **Fig. 1** erläuterten Ultraschall-Verlegung des Drahtleiters 20 wird die Ultraschallbeaufschlagung des Drahtleiters 20, während dieser beim Verlegevorgang über die Substratausnehmung hinweggeführt wird, ausgesetzt, um zum einen keine Beeinträchtigung der Ausrichtung des Drahtleiters 20 in einem Freispannbereich 47 zwischen den einander gegenüberliegenden Ausnehmungsrändern 48, 49 zu erzielen, und zum anderen, um eine Beanspruchung der Verbindung zwischen dem Drahtleiter 20 und dem Substrat 42 im Bereich der Ausnehmungränder 48, 49 durch Zugbelastungen des Drahtleiters 20 infolge einer Ultraschallbeaufschlagung auszuschließen.

**Fig. 5** zeigt in einer gegenüber **Fig. 4** abgewandelten Konfiguration eine Spule 50 mit einem Spulenanfangsbereich 51 und einem Spulenendbereich 52, die in einen Innenbereich der Spule 50 abgewinkelt zu einem Spulenhauptstrang 53 hineingeführt sind. Die Spule 50 ist auf einem Substrat 55 angeordnet, das eine Substratausnehmung 56 im Innenbereich 53 der Spule 50 aufweist Um sowohl den Spulenanfangsbereich 51 als auch den Spulenendbereich 52 über die Substratausnehmung 56 hinwegführen zu können, muß bei der in **Fig. 5** dargestellten Konfiguration der Spulenendbereich 52 zuvor über den Spulenhauptstrang 44 in einem Überquerungsbereich 57 hinweggeführt werden um hierbei Beschädigungen oder eine teilweise Abisolierung des Drahtleiters 20 zu verhindern, wird ähnlich wie im Bereich der

Substratausnehmung 56 die Ultraschallbeaufschlagung des Drahtleiters 20 im Überquerungsbereich 57 ausgesetzt Darüber hinaus wird der Drahtführer 23 im Überquerungsbereich 57 geringfügig angehoben.

**Fig. 6** zeigt in einer Ansicht des Substrats 55 entsprechend dem Schnittlinienverlauf VI-VI in **Fig. 5** die Plazierung einer Chipeinheit 58 in der Substratausnehmung 56, bei der Anschlußflächen 59 der Chipeinheit 58 gegen den Spulenanfangsbereich 51 und den Spulenendbereich 52 zur Anlage gebracht werden.

**Fig. 7** zeigt die nachfolgende Verbindung der Anschlußflächen 59 der Chipeinheit 58 mit dem Spulenanfangsbereich 51 und dem Spulenendbereich 52 mittels einer Thermode 60, die unter Einwirkung von Druck und Temperatur eine stoffschlüssige Verbindung zwischen dem Drahtleiter 20 und den Anschlußflächen 59 schafft, wodurch insgesamt ein Kartenmodul 64 ausgebildet wird.

Bei der in den **Fig. 6** und **7** dargestellten Chipeinheit 58 kann es sich auch wie in allen anderen übrigen Fällen, wenn von einer Chipeinheit gesprochen wird, sowohl um einen einzelnen Chip als auch um ein Chipmodul, das etwa einen auf einem Chipsubstrat kontaktierten Chip oder auch eine Mehrzahl von Chips aufweist, handeln. Darüber hinaus ist die in den **Fig. 6** und **7** dargestellte Verbindung zwischen der Spule 50 und den Anschlußflächen 59 nicht auf die Verbindung mit einem Chip beschränkt, sondern gilt allgemein für die Verbindung von Anschlußflächen 59 aufweisenden elektronischen Bauelementen mit der Spule 50. Dabei kann es sich beispielsweise auch um Kondensatoren handeln.

Ferner wird aus den **Fig. 6** und **7** deutlich, daß die Substratausnehmung 56 so bemessen ist, daß sie die Chipeinheit 58 im wesentlichen aufnimmt. Zur Vereinfachung der Ausrichtung der Anschlußflächen 59 der Chipeinheit 58 bei der der eigentlichen Kontaktierung vorausgehenden Plazierung der Chipeinheit 58 kann die Chipeinheit 58 auf ihrer die Anschlußflächen 59 aufweisenden Kontaktseite 61 mit einer hier stegartig ausgebildeten Ausrichtungshilfe 62 versehen sein. Die Ausrichtungshilfe 62 ist entsprechend dem Abstand a bemessen, die der Spulenanfangsbereich 51 und der Spulenendbereich 52 im Bereich der Substratausnehmung 56 voneinander haben (**Fig. 5**).

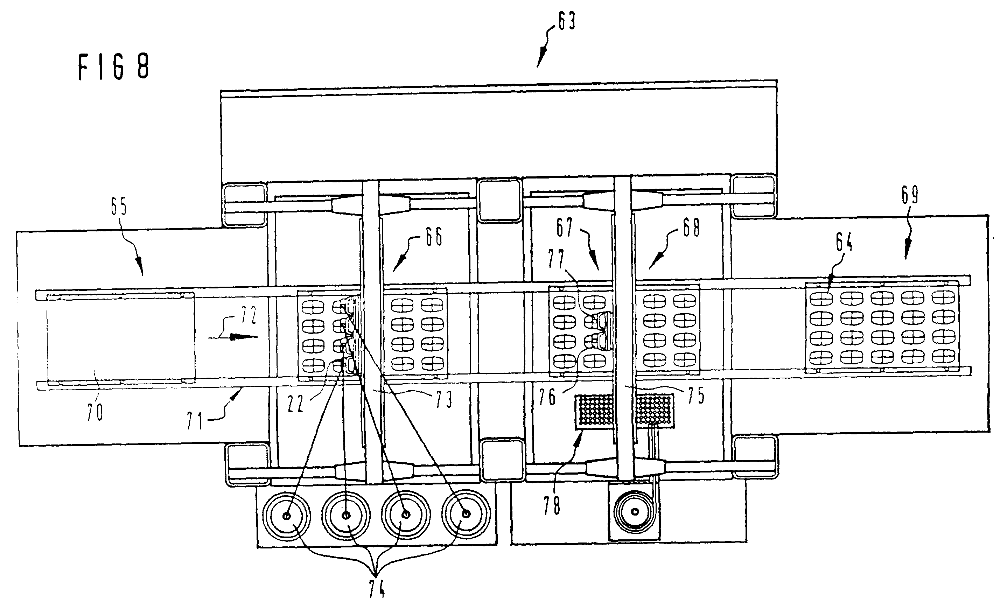

**Fig. 8** zeigt eine Produktionsvorrichtung 63, die zur Herstellung von Kartenmodulen 64 dient, die als Halbzeug bei der Herstellung von Chipkarten Verwendung finden. Die mittels der Produktionsvorrichtung 63 hergestellten Kartenmodule 64.weisen hier beispielhaft den in den **Fig. 5**, 6 und 7 dargestellten Aufbau mit jeweils einer Spule 50 und einer Chipeinheit 58 auf, die auf einem gemeinsamen Substrat 55 angeordnet sind.

Die in **Fig. 8** dargestellte Produktionsvorrichtung 63 weist fünf Stationen, nämlich eine Zuführstation 65, einen Verlegestation 66, eine Bestückungsstation 67 und eine Verbindungsstation 68 sowie eine Entnahmestation 69 auf.

In der Zuführstation wird der Produktionsvorrichtung 63 ein sogenannter Nutzen 70 zugeführt, der in einem gemeinsamen Verbund eine Vielzahl - hier aus Darstellungsgründen lediglich zwanzig - über hier nicht näher dargestellte Trennstellen miteinander verbundene Substrate 55 aufweist. Der Nutzen 70 wird mittels einer Transporteinrichtung 71 der Verlegestation 66 zugeführt, die an einem quer zur Produktionsrichtung 72 verlaufenden, in Produktionsrichtung 72 verfahrbaren Portal 73 vier in einer Reihe angeordnete, identische Verlegevorrichtungen 22 aufweist. Die Verlegevorrichtungen 22 werden über vier Drahtleiterspulen 74 mit dem Drahtleiter 20 versorgt. Zur Ausbildung der in **Fig. 5** beispielhaft dargestellten Spulenkonfigurationen werden die längs dem Portal 73 verfahrbaren Verlegevorrichtungen 22 entsprechend in der Verlegeebene 28 (**Fig. 1**) verfahren.

Nach Verlegung der Drahtleiter 20 entsprechend der in **Fig. 5** dargestellten Spulenkonfiguration wird der Nutzen 70 mit den darauf ausgebildeten Spulen 50 zur Bestückungsstation 67 weiter vorbewegt. Kombiniert mit der Bestückungsstation 67 ist im vorliegenden Fall die Verbindungsstation 68, derart, daß an einem in Produktionsrichtung 72 verfahrbaren Portal 75 sowohl eine Bestückungsvorrichtung 76 als auch eine Verbindungsvorrichtung 77 jeweils in Längsrichtung des Portals 75 verfahrbar angeordnet sind. Dabei dient die Bestückungsvorrichtung 76 zur Entnahme von Chipeinheiten 58 aus einem Chipeinheitenreservoir 78 und zur nachfolgenden Plazierung der Chipeinheiten 58 in der in **Fig. 6** dargestellten Art und Weise. Die Verbindungsvorrichtung 77 dient zur Kontaktierung der Anschlußflächen 59 der Chipeinheiten 58 mit der Spule 50, wie in **Fig. 7** dargestellt.

Nach Bestückung und Kontaktierung wird der Nutzen 70 weiter in die Entnahmestation 69 vorbewegt. Hier erfolgt eine Entnahme des Nutzens 70 mit anschließender Vereinzelung der Substrate 55 oder auch zunächst eine Vereinzelung der Substrate 55, also eine Auflösung des Nutzenverbunds, und anschließend die Entnahme der einzelnen nunmehr zu Kartenmodulen 64 ausgebildeten Substrate 55.

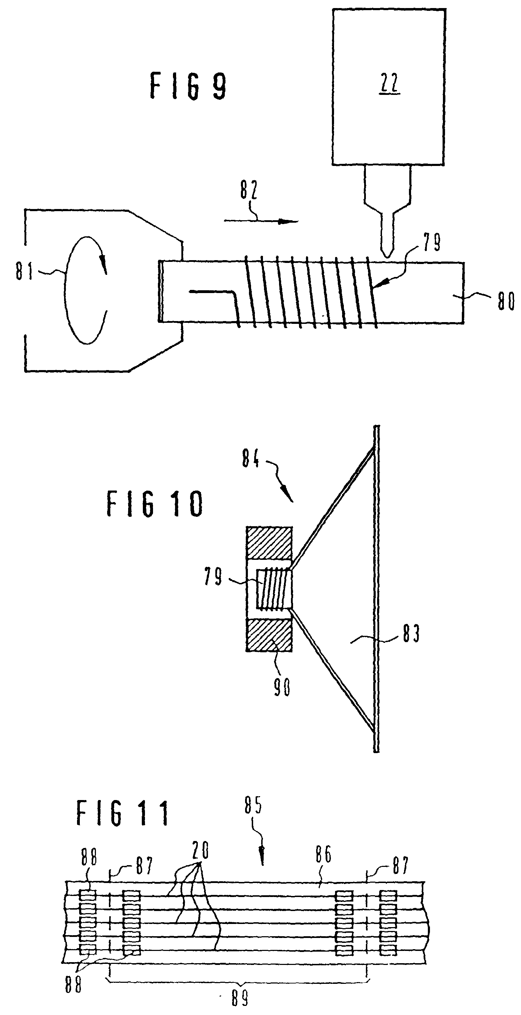

**Fig. 9** zeigt einen Anwendungsfall des beispielhaft anhand **Fig. 1** erläuterten Verfahrens zur Herstellung einer zylindrischen Körperspule 79, bei der das Substrat als zylindrischer Wicklungsträger 80 ausgebildet ist und die Verlegung bzw. Einbettung des Drahtleiters 20 auf dem Wicklungsträger 80 bei Rotation 81 des Wicklungsträgers 80 mit gleichzeitiger überlagerter Translation 82 der Verlegevorrichtung 22 erfolgt.

Wie **Fig. 10** zeigt, kann der Wicklungsträger 80 auch als zylindrischer Fortsatz einer Kunststoffschwingmembran 83 einerLautsprechereinheit 84 ausgebildet sein, so daß auf die in **Fig. 9** dargestellte Art und Weise eine Tauchspule 85 herstellbar ist, wie sie in Kombination mit einem in **Fig. 10** angedeuteten Permanentmagneten zur Ausbildung einer Lautsprechereinheit 84 dient.

**Fig. 11** zeigt als weitere Applikationsmöglichkeit des beschriebenen Verfahrens einen Flachbandkabelabschnitt 85 mit einem flachbandförmig ausgebildeten Substrat 86, das beidseitig benachbart von Trennstellen 87 mit quer zur Längsrichtung des Substrats 86 in einer Reihe liegend angeordneten Substratausnehmungen 88 versehen ist Auf dem Substrat 86 befinden sich parallel zueinander angeordnet und sich in Längsrichtung des Substrats 86 erstreckend eine Mehrzahl von Drahtleitern 20, die auf die in **Fig. 1** beispielhaft dargestellte Art und Weise auf dem Substrat 86 verlegt sind. Dabei sind die Drahtleiter 20 im Bereich der Trennstellen 87 über die Substratausnehmungen 88 hinweggeführt. Die Trennstellen dienen zur Definition vorbestimmter Flachbandkabelstücke 89, wobei dann die Substratausnehmungen 88 jeweils an einem Ende eines Flachbandkabelstücks angeordnet sind. Hierdurch ergeben sich in besonders günstiger Weise Kontaktierungsmöglichkeiten für Anschlußstecker bzw. Anschlußbuchsen mit den Drahtleitern 20, ohne daß hierzu die Drahtleiter erst freigelegt werden müßten. Die Substratausnehmungen 88 werden in einem Stanzverfahren mit einem entsprechend ausgebildeten Stempelwerkzeug in das Substrat 86 eingebracht, wobei durch den Abstand der Einstanzungen der Abstand der Trennstellen 87 vorgegeben ist. Anschließend wird das entsprechend präparierte Endlossubstrat mit den Drahtleitern 20 belegt, wobei in diesem Fall eine der Anzahl der Drahtleiter 20 entsprechende Anzahl von Verlegevorrichtungen über dem längs bewegten Substrat angeordnet wird.

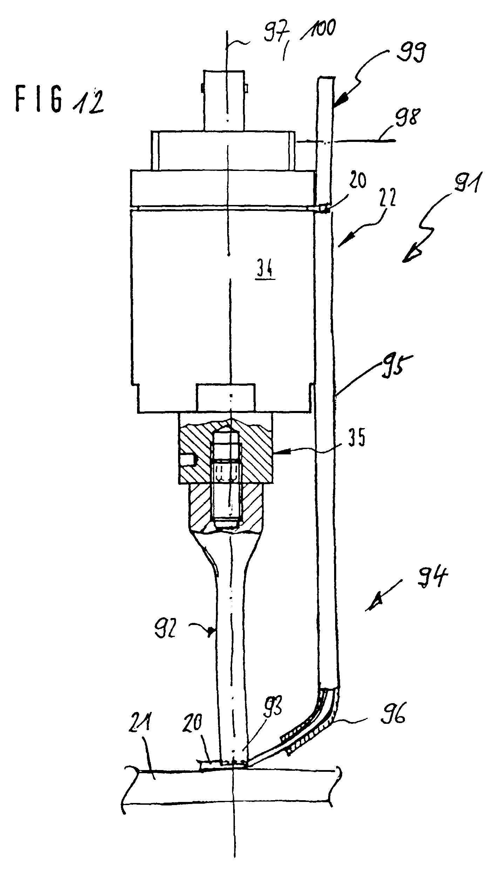

**Fig. 12** zeigt in Abwandlung von der in **Fig. 3** dargestellten Verlegevorrichtung 22 eine Verlegevorrichtung 91 die wie die Verlegevorrichtung 22 einen Ultraschallgeber 34 aufweist. Im Unterschied zu der Verlegevorrichtung 22 ist an den Verbindungsbereich 35 des Ultraschallgebers 34 kein Drahtführer sondern ein Schwingungsstempel 92 angeschlossen, der, wie in **Fig. 12** dargestellt, dazu dient, den zwischen einem Profilende 93 und der Oberfläche des Substrats 21 geführten Drahtleiter 20 mit in Längsrichtung des Schwingungsstempels 92 verlaufenden, durch Ultraschall induzierten mechanischen Schwingungen zu beaufschlagen. Um dabei eine sichere Führung des Drahtleiters 20 zu ermöglichen, ist das Profilende 93 mit einer in **Fig. 12** nicht näher dargestellten konkaven Ausnehmung versehen, die ein teilweises Umgreifen des Drahtleiters 20 ermöglicht.

Im Unterschied zu der in **Fig. 3** dargestellten Verlegevorrichtung 22 ist an der Verlegevorrichtung 91 ein Drahtführer 94 vorgesehen, der bei dem hier dargestellten Ausführungsbeispiel aus einem seitlich am Ultraschallgeber 34 angeordneten Führungsrohr 95 mit einem in Richtung auf das Profilende 93 ausgebildeten Krümmermundstück 96 gebildet ist, das eine hier schräg nach unten gerichtete, seitliche Zuführung des Drahtleiters 20 in Richtung auf das Profilende 93 ermöglicht. Damit kann, wie in **Fig. 12** dargestellt, der Drahtleiter 20 zwischen das Profilende 93 des Schwingungsstempels 92 und die Oberfläche des Substrats 21 geführt werden, um die vorbeschriebene Verbindung mit bzw. Verlegung auf oder in der Oberfläche des Substrats 21 zu ermöglichen.

Abweichend von der Darstellung in **Fig. 12** ist es auch möglich, den Drahtführer vom Ultraschallgeber 34 entkoppelt an der Verlegevorrichtung 91 vorzusehen, um im Bedarfsfall eine schwingungsfreie Zuführung des Drahtleiters zu ermöglichen.

Bei dem in **Fig. 12** dargestellten Ausführungsbeispiel weist die Verlegevorrichtung eine um eine quer zur Stempelachse 97 angeordnete Wickelachse 98 drehbare Drahtspule 99 auf, die zur Zuführung, des Drahtleiters 20 in den Drahtführer 95 dient.

Um ein auf der Oberfläche des Substrats 21 beliebiges Verlegen des Drahtleiters 20 zu ermöglichen, weist die Verlegevorrichtung 91 koaxial zur Stempelachse 97 eine Schwenkachse 100 auf.

In der Sprache der vorliegenden Patentanmeldung bezeichnen die Begriffe "drahtförmiger Leiter" und "Drahtleiter" allgemein Leiter zur Übertragung von Signalen, die eine definierte Längserstreckung aufweisen und daher hinsichtlich ihrer äußeren Form drahtförmig ausgebildet sind. Der Begriff "Drahtleiter" ist jedoch nicht auf metallische Leiter beschränkt, sonder bezeichnet ebenso Leiter aus anderen Materialien, z B. Lichtleiter aus Glasfaser, oder auch Leiter, die zur Führung strömender Medien dienen. Insbesondere in dem Fall, daß die verwendeten Leiter mit einer haftfähigen Oberfläche versehen sind, lassen sich die Leiter auch mehrlagig aufeinander liegend anordnen, wobei die unterste Lage mit der Substratoberfläche und weitere Lagen jeweils mit darunter angeordneten Leiterlagen verbunden sind. Die Haftung kann beispielsweise über eine mittels Wärmebeaufschlagung hinsichtlich ihrer Haftwirkung aktivierbare Backlackbeschichtung des Leiters oder eine entsprechende Kunststoffbeschichtung erreicht werden.

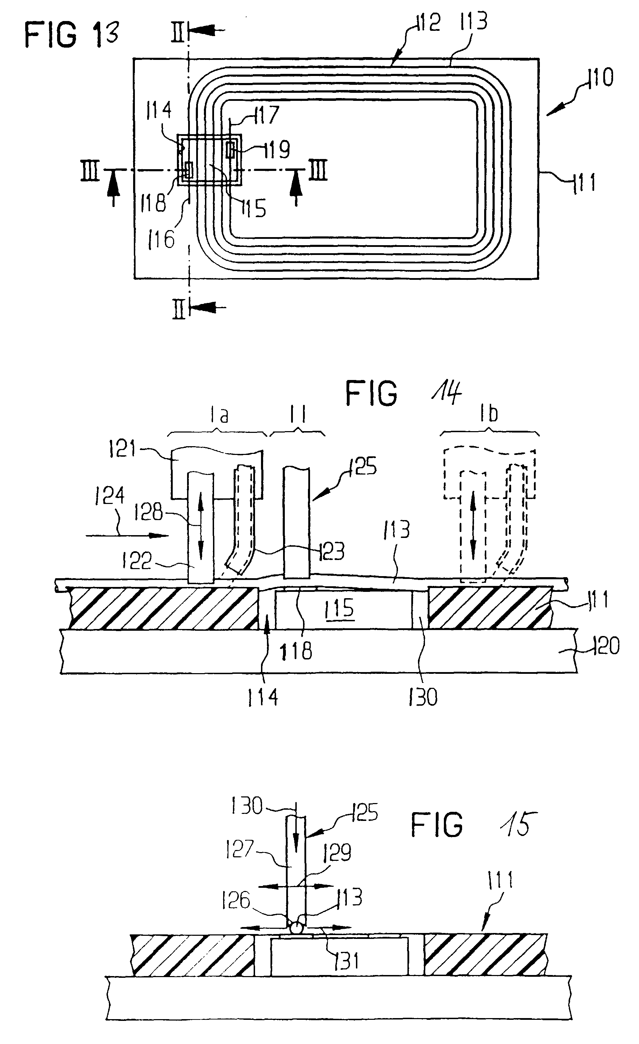

**Fig. 13** ein Karteninlet einer Chipkarte mit einer aus einer Drahtspule und einer Chipeinheit gebildeten Tanspondereinheit;
**Fig. 14** eine Schnittdarstellung des in **Fig. 13** dargestellten Karteninlets gemäß Schnittlinienverlauf II-II zur Erläuterung des Herstellungsverfahrens;
**Fig. 15** eine weitere Schnittdarstellung des in **Fig. 13** dargestellten Karteninlets gemäß Schnittlinienverlauf III-III;

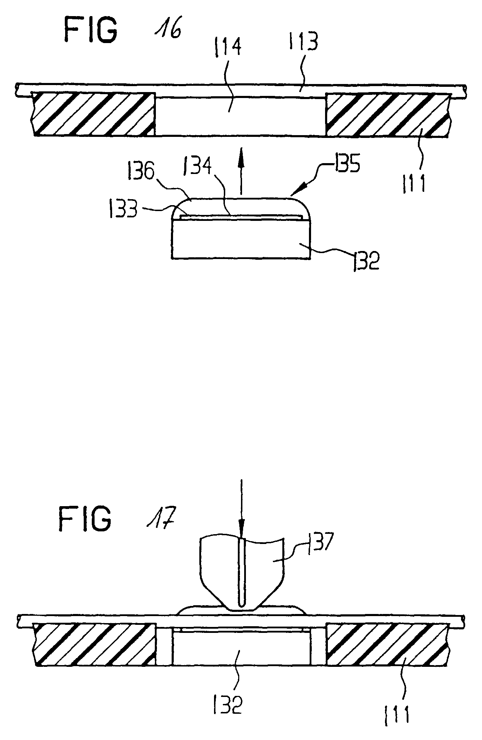

**Fig. 16** eine in der Ansicht **Fig. 14** entsprechende Darstellung zur Erläuterung einer alternativen Verfahrensweise mit nachträglicher Applikation einer Chipeinheit;
**Fig. 17** die Kontaktierung der gemäß **Fig. 17** nachträglich applizierten Chipeinheit;
**Fig. 18** eine mögliche Kontaktmetallisierung einer Chipanschlußfläche bei Kontaktierung gemäß dem in **Fig. 17** dargestellten Verfahren;
**Fig. 19** eine weitere Möglichkeit der Kontaktmetallisierung einer Chipanschlußfläche;

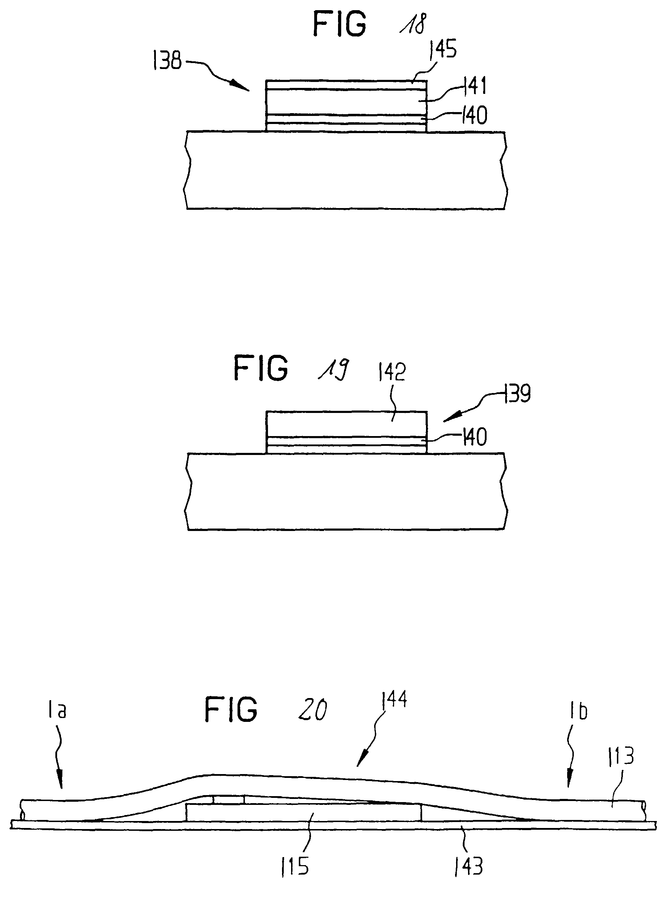

**Fig. 20** eine in der Ansicht **Fig. 14** entsprechende Darstellung einer auf einem Spulensubstrat angeordneten Transpondereinheit.

**Fig. 13** zeigt ein Chipkarteninlet 110, das zur Herstellung einer hier als Endprodukt nicht näher dargestellten Chipkarte mit beidseitigen Deckschichten versehen wird, die in der Regel als Laminatschichten flächendeckend auf das Chipkarteninlet aufgebracht werden.

Das Chipkarteninlet 110 besteht hier aus einem aus Kunststoffmaterial gebildeten Spulensubstrat 111, auf das eine Drahtspule 112 in Verlegetechnik aufgebracht ist. Hierzu wird ein Drahtleiter 113 mittels einer in **Fig. 13** nicht näher dargestellten Verlegeeinrichtung auf der Oberfläche des Spulensubstrats 111 verlegt und durch eine Ultraschallbeaufschlagung teilweise in das Spulensubstrat 111 eingebettet, wie es der **Fig. 14** entnommen werden kann.

Wie weiterhin aus der Darstellung gemäß **Fig. 13** zu ersehen ist, ist im Spulensubstrat 111 eine Ausnehmung 114 vorgesehen, die zur Aufnahme einer hier durch einen einzelnen Chip 115 gebildeten Chipeinheit dient. Die Chipeinheit kann, wie im vorliegenden Fall, lediglich durch den Chip 115 gebildet sein Darüber hinaus ist es jedoch möglich, daß die Chipeinheit aus einem sogenannten "Chipmodul" gebildet ist, das einen oder auch mehrere gehäuste Chips aufnimmt.

Wie weiterhin aus **Fig. 13** zu ersehen ist, ist der zur Ausbildung der Drahtspule 112 auf dem Spulensubstrat 111 verlegte Drahtleiter 113 mit Drahtenden 116, 117 auf jeweils einer zugeordneten Anschlußfläche 118 bzw. 119 des Chips 115 kontaktiert.

Ein Verfahren zur Durchführung der Kontaktierung der Drahtenden 116, 117 mit den Anschlußflächen 118, 119 des Chips 115 soll nachfolgend unter Bezugnahme auf **Fig. 14** näher erläutert werden. Das in **Fig. 14** näher dargestellte Verfahren erfolgt in zwei aufeinanderfolgenden Phasen, die hier zur Unterscheidung mit I und II gekennzeichnet sind. In der mit I bezeichneten Phase erfolgt eine Fixierung des hier abgebildeten Drahtendes 116 auf dem Spulensubstrat 111, wobei gleichzeitig infolge des vorgenannten Verlegeverfahrens zur Aufbringung des Drahtleiters 113 auf die Oberfläche des Spulensubstrats 111 der Drahtleiter 113 über den in der Ausnehmung 114 aufgenommenen Chip 115 hinweggeführt wird. Zur Durchführung des in **Fig. 14** dargestellten Verfahrens ist das Spulensubstrat 111 zusammen mit dem in der Ausnehmung 114 aufgenommenen Chip 115 auf einem Tisch 120 angeordnet.

Als Verlegeeinrichtung wird bei dem in **Fig. 14** dargestellten Verfahrensbeispiel eine Ultraschalleinrichtung 121 verwendet, die mit einem Schwingungsstempel 122 den kontinuierlich aus einem Drahtführer 123 herausgeführten Drahtleiter 113 in die Oberfläche des Spulensubstrats 111 einbettet und dabei gleichzeitig eine Horizontalbewegung 124 auf der Oberfläche des Spulensubstrats 111 ausführt. Diese mit dem Begriff "verlegen" beschriebene Applikation des Drahtleiters 113 auf der Oberfläche des Spulensubstrats 111 erfolgt zunächst in dem mit Ia bezeichneten Bereich links der Ausnehmung 114, anschließend wird der Drahtleiter 113 mit dem Drahtführer 123 über den in der Ausnehmung 114 angeordneten Chip 115 hinweggeführt, um schließlich rechtsseitig der Ausnehmung 114 in dem mit Ib überschriebenen Bereich mit der Fixierung des Drahtleiters 113 mittels Ultraschallbeaufschlagung des Drahtleiters über den Schwingungsstempel 122 fortzufahren. Obwohl bei Verwendung der vorstehend beschriebenen Ultraschalleinrichtung 121 zur Verlegung des Drahtleiters 113 auf dem Spulensubstrat 111 eine sich im wesentlichen über die gesamte Länge des Drahtleiters 113 erstreckende Fixierung desselben auf dem Spulensubstrat 111 ergibt, ist es zur Realisierung des Verfahrensprinzips ausreichend, wenn eine Fixierung des Drahtleiters 113 auf dem Spulensubstrat 111 lediglich in zwei Punkten links und rechts der Ausnehmung 114 erfolgt, um die in **Fig. 14** dargestellte lineare Ausrichtung des Drahtleiters 113 über die Anschlußflächen 118, 119 des Chips 115 zu erzielen.

Nachdem sich der Drahtleiter 113 in der die zugeordnete Anschlußfläche 118 des Chips 115 überspannenden Position befindet, erfolgt in der mit II gekennzeichneten Phase die Verbindung des Drahtleiters 113 mit der Anschlußfläche 118. Hierzu wird bei dem in **Fig. 14** dargestellten Verfahrensbeispiel eine weitere Ultraschalleinrichtung 125 verwendet, die, wie insbesondere aus **Fig. 15** zu ersehen ist, ein mit einer konkaven Ausnehmung versehenes Profilende 126 eines Schwingungsstempels 127 aufweist.

Das vorstehend unter Bezugnahme auf die **Fig. 14** und **15** beschriebene Verfahren bietet auch die Möglichkeit, durch entsprechende Wahl der Fixierungspunkte des Drahtleiters auf dem Substrat, den Drahtleiter diagonal über die Anschlußflächen hinwegzuführen, um die Überdeckung zwischen dem Drahtleiter und den Anschlußflächen zu erhöhen. Auch können auf die in **Fig. 14** dargestellte Art und Weise mehrere Chips oder andere in Reihe liegend auf oder in einem Substrat angeordnete Elemente durch den Drahtleiter verbunden werden.

**Fig. 15** zeigt weiterhin deutlich, daß im Gegensatz zu der durch Ultraschall induzierten Schwingungsbeaufschlagung 128, die in Längsrichtung des Schwingungsstempels 122 der Ultraschalleinrichtung 121 erfolgt, die durch Utraschall induzierte Schwingungsbeaufschlagung 129 des Schwingungsstempels 127 quer zur Längsrichtung des Drahtleiters 113 und parallel zur Oberfläche des Spulensubstrats 111 erfolgt Dieser Schwingungsbeaufschlagung 128 wird ein leichter Anpressdruck 130 überlagert, so daß der geführt im Profilende 126 des Schwingungsstempels 127 aufgenommene Drahtleiter 113 im Bereich der Anschlußfläche 118 unter Druck oszillierend über diese hin- und herbewegt wird. Zum einen ergibt sich hierdurch ein Aufreißen und Abtragen etwaiger auf der Anschlußfläche 118 vorhandener Oxidhäute, zum anderen ergibt sich nachfolgend bei entsprechend hohen oder erhöhten Anpressdruck 130 ein Verschweißen des hier aus Kupfer gebildeten Drahtleiters 113 mit der Aluminiumanschlußfläche 118. Falls der Drahtleiter 113 mit einer äußeren Isolierung versehen ist, läßt sich auch diese durch die oszillierende Hin- und Herbewegung im Bereich der Anschlußfläche 118 entfernen, so daß nachfolgend die vorbeschriebene metallische Verbindung zwischen dem unmittelbar zuvor noch durch die Isolierung gegen Oxidation geschützten Drahtleiter und der Anschlußfläche möglich wird.

In dem in den **Fig. 14** und **15** dargestellten Spulensubstrat 111 ist die Ausnehmung 114 soviel größer als die entsprechenden Abmessungen des Chips 15 vorgesehen, so daß sich ein umlaufender Spalt 130 zwischen dem Chip 115 und den Rändern der Ausnehmung 114 ergibt. Hierdurch ist quasi eine "schwimmende Aufnahme" des Chips 115 in der Ausnehmung 114 möglich, wobei dieser in seiner Relativlage zum Spulensubstrat 111 zwar im wesentlichen definiert ist, jedoch kleinere Relativbewegungen ausführen kann. Hieraus ergibt sich der Vorteil, daß durch den eingangs beschriebenen Laminiervorgang zum Auftrag der beidseitigen Deckschichten auf das Spulensubstrat 111 der Chip den mit dem Laminiervorgang verbundenen Druckbelastungen zumindest teilweise ausweichen kann und somit das Risiko einer Beschädigung des Chips beim Laminiervorgang wesentlich reduziert wird.

Um auch bei der vorstehend beschriebenen "schwimmenden Aufnahme" des Chips in der Ausnehmung 114 eine exakte Positionierung des Drahtleiters 113 auf der Anschlußfläche 118 ausführen zu können, kann der Drahtleiter 113 über eine entsprechende Querbewegungsachse 131 der Ultraschalleinrichtung 125 nachgeführt werden.

Obwohl unter Bezugnahme auf das in den **Fig. 14** und **15** dargestellte Verfahrensbeispiel vorstehend von zwei unterschiedlichen Ultraschalleinrichtungen 121 und 125 die Rede war, besteht auch die Möglichkeit, bei entsprechender Ausführung der Ultraschalleinrichtung 121 diese sowohl zur Verlegung bzw. Fixierung des Drahtleiters auf der Oberfläche des Spulensubstrats 111 als auch zur Verbindung des Drahtleiters 113 mit der jeweils zugeordneten Anschlußfläche 118 bzw. 119 zu verwenden.

In den **Fig. 16** und **17** ist eine gegenüber den **Fig. 14** und **15** leicht variierte Vorgehensweise dargestellt, bei der ein Chip 132 erst nach Fixierung des Drahtleiters 113 auf der Oberfläche des Spulensubstrats 111 beidseitig der Ausnehmung 114 in diese eingeführt wird. Um gleichzeitig mit dem Einführen des Chips 132 in die Ausnehmung 114 eine für die nachfolgende Kontaktierung des Drahtleiters 113 mit einer zugeordneten Anschlußfläche 133 des Chips 132 geeignete Positionierung zu ermöglichen, ist dieser auf seiner Kontaktseite 134 mit jeweils benachbart einer Anschlußfläche 133 angeordneten, stegartigen Ausrichtungshilfen 135 versehen, die über Führungsschrägen 136 für eine korrekte Relativpositionierung sorgen.

**Fig. 17** zeigt außerdem eine alternativ zur Ultraschalleinrichtung 125 als Verbindungseinrichtung einsetzbare Thermodeneinrichtung 137, die eine Verbindung des Drahtleiters unter Druck und Temperaturbeaufschlagung mit der zugeordneten Anschlußfläche 133 ermöglicht. Grundsätzlich besteht auf bei beiden in den **Fig. 14, 15** bzw. **17** dargestellten Verbindungsverfahren die Möglichkeit, die Verbindung zwischen dem Drahtleiter und den Anschlußflächen durch eine Überlagerung von Ultraschall- und Temperaturbeaufschlagung herzustellen, beispielsweise durch eine beheizbare Ultraschalleinrichtung.

Um eine Verbindung des Kupfer-Drahtleiters 113 mit den Aluminium-Anschlußflächen 133 des Chips 132 zu ermöglichen, sind die Anschlußflächen 133 mit einer Kontaktmetallisierung 138 (**Fig. 18**) oder 139 (**Fig. 19**) versehen. Die Kontaktmetallisierungen 138, 139 weisen übereinstimmend eine als Zwischenschicht 140 dienende Zinkatschicht auf, die als Grundlage für eine hierauf aufgetragene Nickelschicht 141 im Falle der Kontaktmetallisierung 138 oder Palladiumschicht 142 im Falle der Kontaktmetallisierung 139 dient. Zur Verbesserung der Verbindungseigenschaft bzw. zur Erhöhung der Oxidationsbeständigkeit ist die Nickelschicht 141 noch mit einem Goldüberzug 145 versehen. Zur Verdeutlichung der Größenabmessungen werden nachfolgend beispielhaft Schichtstärken, der auf die etwa 1 bis 2 µm starke Aluminiumbeschichtung der Anschlußfläche 133 aufgetragenen Schichten angegeben:
- Zinkatschicht:: d = 150 nm;
- Nickelschicht :: d = 1 - 5 µm
- Palladiumschicht:: d = 1 - 5 µm;
- Gold-Überzug :: d = 100 - 150 nm.

**Fig. 20** zeigt schließlich noch in einer Variante zu der Darstellung gemäß **Fig. 13**, die Möglichkeit, das vorstehend beschriebene Verfahren zur Direktkontaktierung des Drahtleiters 113 mit zugeordneten Anschlußflächen 118 bzw. 119 des Chips 115 auch anzuwenden, wenn der Chip 115 nicht in einer Ausnehmung, sondern vielmehr auf der Oberfläche eines Substrats 143 angeordnet ist. Bei dem in **Fig. 20** dargestellten Substrat 143 kann es sich beispielsweise um ein Papiersubstrat oder auch ein beliebig anderes Substrat handeln. Übereinstimmend mit dem unter Bezugnahme auf die **Fig. 14** und **15** erläuterten Verfahren ist auch hier beidseitig eines Aufnahme- bzw Anordnungsbereichs 144 für den Chip 115 eine Fixierung des Drahtleiters 113 in den hier vereinfacht mit Ia und Ib bezeichneten Oberflächenbereichen des Substrats 143 vorgesehen.

Die in **Fig. 20** dargestellte Ausführungsform erscheint insbesondere wegen des besonders dünn ausgebildeten Substrats besonders für die Verwendung als Transponderanordnung bei der Gepäckidentifizierung geeignet. Obwohl in den vorstehenden Ausführungsbeispielen zur Erläuterung des Verfahrens Bezug genommen wird auf aus einer kernlosen Drahtspule und einer Chipeinheit bestehende Transpondereinheiten, können natürlich auch Ferritkernspulen, wie sie beispielsweise zur Herstellung von Tiertranspondern eingesetzt werden, verwendet werden.

In jedem Fall kann der Chip oder die Chipeinheit vor oder nach der Applikation auf bzw. im Substrat gedünnt werden, um die Flexibilität des Chips zu erhöhen und den Chip gegebenenfalls im Biegeverhalten an das Substrat anzupassen.

## Patentansprüche

1. Verfahren zur Kontaktierung eines auf einem Substrat (111) angeordneten Drahtleiters (113) bei der Herstellung einer auf einem Substrat (111) angeordneten, eine Drahtspule (112) und eine Chipeinheit (115) aufweisenden Transpondereinheit, bei dem in einer ersten Phase der Drahtleiter (113) über eine Anschlußfläche (118, 119) der Chipeinheit oder einen die Anschlußfläche aufnehmenden Bereich hinweggeführt und relativ zur Anschlußfläche (118, 119) bzw. dem der Anschlußfläche zugeordneten Bereich auf dem Substrat (111) fixiert wird, und in einer zweiten Phase die Verbindung des Drahtleiters (113) mit der Anschlußfläche (118, 119) mittels einer Verbindungseinrichtung (125, 137) erfolgt.

2. Verfahren nach Anspruch 1,
dadurch **gekennzeichnet**,
daß zur Verbindung des Drahtleiters mit der Anschlußfläche eine Ultraschalleinrichtung verwendet wird.

3. Verfahren nach Anspruch 1,
dadurch **gekennzeichnet,**
daß sowohl zur Verbindung des Drahtleiters mit der Anschlußfläche als auch zur Anordnung der Drahtspule auf dem Substrat eine Ultra schalleinrichtung verwendet wird.

4. Verfahren nach Anspruch 1 oder 3,
dadurch **gekennzeichnet**,
daß die Anordnung der Drahtspule auf dem Substrat des Drahtleiters mittels einer als Ultraschalleinrichtung ausgebildeten Verlegevorrichtung erfolgt, derart, daß der Drahtleiter (20) in einer Richtung quer zur Verlegeebene (28) mit Ultraschall beaufschlagt wird, und die durch die Ultraschallbeaufschlagung erzeugte Querbewegung (24) der Verlegevorrichtung (22) der in der Verlegeebene (28) verlaufenden Verlegebewegung (29) überlagert wird.

5. Verfahren nach einem oder mehreren der vorangehenden Ansprüche,
dadurch **gekennzeichnet**,
daß die Querbewegung (24) längs einer im Winkel zur Achse der Verlegebewegung (29) veränderbaren Querbewegungsachse erfolgt.

6. Verfahren nach einem oder mehreren der vorangehenden Ansprüche,
dadurch **gekennzeichnet**,
daß die Ultraschallfrequenz und/oder der Winkel zwischen der Achse der Verlegebewegung (29) und der Querbewegungsachse (24) in Abhängigkeit von der gewünschten Eindringtiefe des Drahtleiters (20) verändert wird.

7. Anwendung des Verfahrens nach einem oder mehreren der vorangehenden Ansprüche zur Anordnung einer eine Spule und eine Chipeinheit aufweisenden Transpondereinheit auf einem Substrat
dadurch **gekennzeichnet,**
daß ein Spulenendbereich (44) und ein Spulenanfangsbereich (43) einer durch die Verlegung auf dem Substrat (21) ausgebildeten Spule (41) über eine Substratausnehmung (45) hinweggeführt werden.

8. Verfahren nach Anspruch 7,
dadurch **gekennzeichnet**,
daß die Ultraschallbeaufschlagung des Drahtleiters (20) im Bereich der Substratausnehmung (45) ausgesetzt wird.

9. Verfahren nach einem oder mehreren der vorangehenden Ansprüche,
dadurch **gekennzeichnet,**
daß zur Überquerung eines bereits verlegten Drahtabschnitts im Überquerungsbereich (57) die Ultraschallbeaufschlagung des Drahtleiters (20) ausgesetzt und der Drahtleiter (20) in einer gegenüber der Verlegeebene (28) beabstandeten Überquerungsebene geführt wird.

10. Anwendung des Verfahrens nach einem oder mehreren der Ansprüche 4 bis 9 zur Herstellung eines Kartenmoduls (64) mit einem Substrat (55), einer auf dem Substrat verlegten Spule (50) und einer mit der Spule (50) verbundenen Chipeinheit (58), wobei in einer Verlegephase mittels der Verlegevorrichtung (22) eine Spule (50) mit einem Spulenanfangsbereich (51) und einem Spulenendbereich (52) auf dem Substrat (55) ausgebildet wird und in einer nachfolgenden Verbindungsphase mittels einer Verbindungsvorrichtung (60) eine Verbindung zwischen dem Spulenanfangsbereich (51) und dem Spulenendbereich (52) mit Anschlußflächen (59) der Chipeinheit (58) durchgeführt wird.

11. Verfahren nach Anspruch 10,
dadurch **gekennzeichnet,**
daß das Substrat aus einem vliesartigen Material, insbesondere Papier oder Karton, besteht und die bei der Verlegung erfolgende Verbindung mittels einer zwischen dem Drahtleiter (20) und der Substratoberfläche angeordneten Kleberschicht erfolgt.

12. Verfahren nach Anspruch 10 oder 11,
dadurch **gekennzeichnet,**
daß die Verbindung des Spulenanfangsbereichs (51) und des Spulenendbereichs (52) mit den Anschlußflächen (59) der Chipeinheit (58) mittels eines Thermokompressionsverfahrens erfolgt.

13. Verfahren nach einem der Ansprüche 10 bis 12,
dadurch **gekennzeichnet,**
daß gleichzeitig die Herstellung einer Mehrzahl von Kartenmodulen (64) erfolgt, derart, daß in einer Zuführphase einer eine Mehrzahl von Verlegevorrichtungen (22) und Verbindungsvorrichtungen (60) aufweisenden Produktionsvorrichtung (72) eine Mehrzahl von einem Nutzen (70) zusammengefaßten Substraten (55) zugeführt wird,
anschließend in der Verlegephase eine Mehrzahl von Spulen (50) gleichzeitig auf in einer Reihe angeordneten Substraten (55) ausgebildet wird,
anschließend in der Verbindungsphase eine Mehrzahl von Chipeinheiten (58) über ihre Anschlußflächen (59) mit den Spulen (50) verbunden wird, und
schließlich in einer Vereinzelungsphase eine Vereinzelung der Kartenmodule (64) aus dem Nutzenverbund erfolgt.

14. Anwendung des Verfahrens nach einem oder mehreren der Ansprüche 4 bis 9 zur Herstellung einer rotationssymmetrischen Körperspule,
dadurch **gekennzeichnet**,
daß der Drahtleiter (20) auf einem als Wicklungsträger (80) ausgebildeten, relativ zur Verlegevorrichtung (22) rotierenden Substrat verlegt wird.

15. Verfahren nach Anspruch 14,
**gekennzeichnet** durch
die Herstellung einer einstückig mit einer Schwingmembran verbundenen Tauchspule einer Lautsprechereinheit.

16. Anwendung des Verfahrens nach einem der Ansprüche 4 bis 9,
dadurch **gekennzeichnet**,
daß eine der Anzahl der gewünschten Kabelleiter entsprechende Anzahl von Verlegevorrichtungen (22) quer zur Längsachse eines flachbandförmigen Substrats (86) angeordnet ist und eine Relativbewegung zwischen dem Substrat (86) und den Verlegevorrichtungen (22) in Längsachsenrichtung des Substrats (86) erfolgt.

17. Verfahren nach einem oder mehreren der vorangehenden Ansprüche,
dadurch **gekennzeichnet**,
daß vor der Verbindung des Drahtleiters (113) mit der Anschlußfläche (118, 119) eine Vorbehandlung der Aluminiumoberfläche der Anschlußfläche (118, 119) erfolgt.

18. Verfahren nach Anspruch 17,
dadurch **gekennzeichnet,**
daß zur Vorbehandlung eine mechanische Beseitigung einer auf der Aluminiumoberfläche angeordneten Oxidschicht mittels Beaufschlagung der Anschlußfläche (118, 119) durch die Ultraschalleinrichtung (125) erfolgt.

19. Verfahren nach Anspruch 17,
dadurch **gekennzeichnet,**
daß die Aluminiumoberfläche zur Vorbehandlung mit einem Reinigungsverfahren beaufschlagt wird.

20. Verfahren nach Anspruch 19,
dadurch **gekennzeichnet,**
daß als Reinigungsverfahren ein Trockenätzverfahren, ein Naßätzverfahren oder eine Laserbeaufschlagung der Aluminiumoberfläche eingesetzt wird.

21. Verfahren nach Anspruch 17,
dadurch **gekennzeichnet**,
daß die Aluminiumoberfläche zur Vorbehandlung mit einer mehrschichtigen Kontaktmetallisierung (138, 139) mit einer auf die Aluminiumfläche als Zwischenschicht (140) aufgebrachten Zinkatschicht und einer für die Kontaktierung mit dem Drahtleiter (113) vorgesehenen Verbindungsschicht (141, 142) versehen wird

22. Verfahren nach Anspruch 21,
dadurch **gekennzeichnet**,
daß die Verbindungsschicht als eine Nickel- oder Palladium aufweisende Schicht ausgebildet ist.

23. Verfahren nach einem oder mehreren der vorangehenden Ansprüche,
dadurch **gekennzeichnet**,
daß die durch Ultraschall bewirkte Schwingungsbeaufschlagung des Drahtleiters (113) in einer im wesentlichen zur Anschlußfläche (118, 119) parallelen Ebene und quer zur Längsachse des Drahtleiters (113) erfolgt

24. Verfahren nach Anspruch 23,
dadurch **gekennzeichnet**,
daß die durch Ultraschall bewirkte Schwingungsbeaufschlagung des Drahtleiters (113) zur bereichsweisen Entferung einer Drahtleiterisolierung dient

25. Verfahren nach einem oder mehreren der vorangehenden Ansprüche,
dadurch **gekennzeichnet,**
daß die Fixierung des Drahtleiters (113) auf einem Kunststoffträgerbogen erfolgt, der zusammen mit dem Drahtleiter (113) und dem Chip (115) ein Karteninlet (110) zur Herstellung einer Chipkarte bildet.

26. Verfahren nach Anspruch 25,
dadurch **gekennzeichnet**,
daß die Fixierung des Drahtleiters (113) auf dem Kunststoffträgerbogen und die Verbindung des Drahtleiters mit den Anschlußflächen des Chips (115) zur Ausbildung einer mechanischen Aufhängung des Chips am Kunststoffträgerbogen dient.

27. Verfahren nach einem oder mehreren der vorangehenden Ansprüche,
dadurch **gekennzeichnet**,
daß die Fixierung des Drahtleiters (113) durch Verlegung mit einer eine Ultraschalleinrichtung aufweisenden Verlegevorrichtung erfolgt.

28. Verfahren nach Anspruch 25,
dadurch **gekennzeichnet**,
daß die Ultraschalleinrichtung (121) zur Verlegung des Drahtleiters (113) auf dem Trägerbogen eine Schwingungsbeaufschlagung des Drahtleiters (113) quer zur Längsachse des Drahtleiters (113) und quer zur Oberfläche des Trägerbogens bewirkt, und die Ultraschalleinrichtung (125) zur Verbindung des Drahtleiters (113) mit der Anschlußfläche (118, 119) eine Schwingungsbeaufschlagung des Drahtleiters (113) in einer im wesentlichen zum Trägerbogen parallelen Ebene und quer zur Längsachse des Drahtleiters (113) bewirkt.

29. Vorrichtung zur Durchführung des Verfahrens nach einem oder mehreren der Ansprüche 1 bis 28 mit einem Drahtführer (23) und einem Ultraschallgeber (34), wobei der Ultraschallgeber (34) derart mit dem Drahtführer (23) verbunden ist, daß der Drahtführer (23) zur Ausführung von Ultraschallschwingungen in Längsachsenrichtung angeregt wird.

30. Vorrichtung nach Anspruch 29,
**gekennzeichnet** durch
einen den Drahtquerschnitt des Drahtleiters (113) teilweise umfassenden Schwingungsstempel (127) und einen Ultraschalloszillator, der eine Schwingungsbeaufschlageung des Schwingungsstempels (127) quer zur Längsachse des in einem Profilende (126) des Schwingungsstempels (127) geführten Drahtleiters (113) bewirkt.

31. Vorrichtung nach Anspruch 30,
dadurch **gekennzeichnet**,
daß die Ultraschalleinrichtung (125) gekoppelt ist mit einer Verlegeeinrichtung.

32. Vorrichtung nach Anspruch 30 oder 31,
dadurch **gekennzeichnet,**
daß der Ultraschalloszillator der Ultraschalleinrichtung (125) gleich zeitig zur Ultraschallbeaufschlagung der Verlegeeinrichtung dient.

33. Vorrichtung nach Anspruch 32,
dadurch **gekennzeichnet**,
daß der Ultraschalloszillator derart angeordnet ist, daß die Achse seiner Wirkrichtung veränderbar ist.

34. Vorrichtung zur Verlegung eines drahtförmigen Leiters auf einem Substrat gemäß dem Verfahren nach einem oder mehreren der Ansprüche 1 bis 28 mit einem Drahtführer (94) und einem Ultraschallgeber (34), wobei der Drahtführer (94) neben einem mit dem Ultraschallgeber (34) gekoppelten Schwingungsstempel (92) zur Beaufschlagung des Drahtleiters (20) mit durch Ultraschall induzierten, in Längsrichtung des Schwingungsstempels wirkenden, mechanischen Schwingungen angeordnet ist.

35. Vorrichtung nach Anspruch 34,
**gekennzeichnet** durch
eine mit einer Schwingungsstempelachse (97) koaxiale Schwenkachse (100).

36. Vorrichtung nach einem oder mehreren der Ansprüche 29 bis 35,
dadurch **gekennzeichnet,**
daß der Drahtführer (23) eine Drahtführungskapillare (37) aufweist, die zumindest im Bereich eines Drahtführermundstücks (30) längsachsenparallel im Drahtführer (23) verläuft.

37. Vorrichtung nach Anspruch 36,
dadurch **gekennzeichnet**,
daß der Drahtführer (23) beabstandet zum Drahtführermundstück (30) mindestens einen schräg zur Drahtführerlängsachse verlaufenden Drahtzuführkanal (38, 39) aufweist.

38. Vorrichtung nach einem oder mehreren der Ansprüche 29 bis 37,
dadurch **gekennzeichnet**,
daß der Ultraschallgeber (34) koaxial zum Drahtführer (23) angeordnet ist.

39. Vorrichtung zur Durchführung des Verfahrens nach einem oder mehreren der Ansprüche 10 bis 28 zur Herstellung eines Kartenmoduls unter Verwendung einer Vorrichtung nach einem oder mehreren der Ansprüche 29 bis 38, aufweisend:
eine Nutzenzuführstation (65) zur Zuführung einer Mehrzahl von in einem Nutzen (70) angeordneten Substraten (55),
eine Verlegestation (66) mit einer Mehrzahl in einer Reihe quer zur Produktionsrichtung angeordneten Verlegevorrichtungen (22),
eine Bestückungsstation (67) mit mindestens einer Bestückungsvorrichtung (76) zur Bestückung der einzelnen Substrate (55) mit einer Chipeinheit (58) und
eine Verbindungsstation (68) mit mindestens einer Verbindungsvorrichtung (77) zur Verbindung der Chipeinheiten mit einem Spulenanfangsbereich (51)und einem Spulenendbereich (52) der von den Verlegevorrichtungen (22) auf den Substraten (55) ausgebildeten Spulen (50).

## Claims

1. Process for the contacting of a wire conductor (113) arranged on a substrate (111) in the course of the manufacture of a transponder unit arranged on a substrate (111) and comprising a wire coil (112) and a chip unit (115), wherein in a first phase the wire conductor (113) is guided away via a terminal area (118, 119) of the chip unit or a region accepting the terminal area and is fixed on the substrate (111) relative to the terminal area (118, 119) or the region assigned to the terminal area, and in a second phase the connection of the wire conductor (113) to the terminal area (118, 119) is effected by means of a connecting instrument (125, 137).

2. Process according to Claim 1,
characterised in that
for the purpose of connecting the wire conductor to the terminal area use is made of an ultrasonic instrument.

3. Process according to Claim 1,
characterised in that
both for the purpose of connecting the wire conductor to the terminal area and for the purpose of arranging the wire coil on the substrate use is made of an ultrasonic instrument.

4. Process according to Claim 1 or 3,
characterised in that
the arrangement of the wire coil on the substrate of the wire conductor is effected by means of a wiring device taking the form of an ultrasonic instrument in such a way that the wire conductor (20) is subjected to the action of ultrasound in a direction transverse to the wiring plane (28) and the transverse movement (24) of the wiring device (22) generated by the ultrasonic loading is superimposed on the wiring movement (29) extending in the wiring plane (28).

5. Process according to one or more of the preceding claims,
characterised in that
the transverse movement (24) takes place along a transverse-movement axis that is variable as regards its angle in relation to the axis of the wiring movement (29).

6. Process according to one or more of the preceding claims,
characterised in that
the ultrasonic frequency and/or the angle between the axis of the wiring movement (29) and the transverse-movement axis (24) is varied as a function of the desired depth of penetration of the wire conductor (20).

7. Application of the process according to one or more of the preceding claims for the arrangement of a transponder unit comprising a coil and a chip unit on a substrate,
characterised in that
a final coil region (44) and an initial coil region (43) of a coil (41) which is formed on the substrate (21) by the wiring are guided away via a substrate recess (45).

8. Process according to Claim 7,
characterised in that
the ultrasonic loading of the wire conductor (20) is interrupted in the region of the substrate recess (45).

9. Process according to one or more of the preceding claims,
characterised in that
for the purpose of crossing a wire section that has already been wired the ultrasonic loading of the wire conductor (20) is interrupted in the crossing region (57) and the wire conductor (20) is guided in a crossing plane that is spaced in relation to the wiring plane (28).

10. Application of the process according to one or more of Claims 4 to 9 for the manufacture of a card module (64) having a substrate (55), a coil (50) wired on the substrate and a chip unit (58) connected to the coil (50), whereby in a wiring phase a coil (50) having an initial coil region (51) and a final coil region (52) is formed on the substrate (55) by means of the wiring device (22) and in a subsequent connection phase a connection is implemented between the initial coil region (51) and the final coil region (52) to terminal areas (59) of the chip unit (58) by means of a connecting device (60).

11. Process according to Claim 10,
characterised in that
the substrate consists of a fleece-type material, in particular paper or cardboard, and the connection which is made in the course of the wiring is effected by means of a layer of adhesive disposed between the wire conductor (20) and the surface of the substrate.

12. Process according to Claim 10 or 11,
characterised in that
the connection of the initial coil region (51) and of the final coil region (52) to the terminal areas (59) of the chip unit (58) is effected by means of a thermocompression process.

13. Process according to one of Claims 10 to 12,
characterised in that
the manufacture of a plurality of card modules (64) takes place simultaneously in such a way that in a supply phase a plurality of substrates (55) combined to form a yield (70) are supplied to a production device (72) comprising a plurality of wiring devices (22) and connecting devices (60), subsequently in the wiring phase a plurality of coils (50) are formed simultaneously on substrates (55) arranged in a row,
then in the connection phase a plurality of chip units (58) are connected via their terminal areas (59) to the coils (50), and
finally in a separation phase a separation of the card modules (64) from the composite yield takes place.

14. Application of the process according to one or more of Claims 4 to 9 for the manufacture of a rotationally symmetrical formed coil,
characterised in that
the wire conductor (20) is wired on a substrate taking the form of a winding support (80) and rotating relative to the wiring device (22).

15. Process according to Claim 14,
characterised by
the manufacture of a moving coil of a loudspeaker unit which is integrally connected to a vibrating diaphragm.

16. Application of the process according to one of Claims 4 to 9,
characterised in that
a number of wiring devices (22) corresponding to the number of cable conductors desired are arranged transverse to the longitudinal axis of a ribbon-shaped substrate (86) and a relative movement between the substrate (86) and the wiring devices (22) takes place in the direction of the longitudinal axis of the substrate (86).

17. Process according to one or more of the preceding claims,
characterised in that
prior to the connection of the wire conductor (113) to the terminal area (118, 119) a preparatory treatment of the aluminium surface of the terminal area (118, 119) takes place.

18. Process according to Claim 17,
characterised in that
with a view to preparatory treatment a mechanical elimination of an oxide layer disposed on the aluminium surface is effected by subjecting the terminal area (118, 119) to the action of the ultrasonic instrument (125).

19. Process according to Claim 17,
characterised in that
with a view to preparatory treatment the aluminium surface is subjected to a cleansing process.

20. Process according to Claim 19,
characterised in that
by way of cleansing process a dry-etching process, a wet-etching process or a laser treatment of the aluminium surface is employed.

21. Process according to Claim 17,
characterised in that
with a view to preparatory treatment the aluminium surface is provided with a multilayered contact metallisation (138, 139) having a zincate layer which is applied by way of intermediate layer (140) onto the aluminium face and having an interconnect layer (141, 142) which is provided for the contacting with the wire conductor (113).

22. Process according to Claim 21,
characterised in that
the interconnect layer takes the form of a layer comprising nickel or palladium.

23. Process according to one or more of the preceding claims,
characterised in that
the vibrational loading of the wire conductor (113) brought about by ultrasound takes place in a plane substantially parallel to the terminal area (118, 119) and transverse to the longitudinal axis of the wire conductor (113).

24. Process according to Claim 23,
characterised in that
the vibrational loading of the wire conductor (113) brought about by ultrasound serves for regional removal of a wire-conductor insulation.

25. Process according to one or more of the preceding claims,
characterised in that
the fixation of the wire conductor (113) is effected on a plastic support sheet which together with the wire conductor (113) and the chip (115) forms a card inlet (110) for the manufacture of a chip card.

26. Process according to Claim 25,
characterised in that
the fixation of the wire conductor (113) on the plastic support sheet and the connection of the wire conductor to the terminal areas of the chip (115) serves to form a mechanical suspension of the chip on the plastic support sheet.

27. Process according to one or more of the preceding claims,
characterised in that
the fixation of the wire conductor (113) is effected by wiring with a wiring device comprising an ultrasonic instrument.

28. Process according to Claim 25,
characterised in that
the ultrasonic instrument (121) for the wiring of the wire conductor (113) on the support sheet brings about a vibrational loading of the wire conductor (113) transverse to the longitudinal axis of the wire conductor (113) and transverse to the surface of the support sheet, and the ultrasonic instrument (125) for the connection of the wire conductor (113) to the terminal area (118, 119) brings about a vibrational loading of the wire conductor (113) in a plane substantially parallel to the support sheet and transverse to the longitudinal axis of the wire conductor (113).

29. Device for implementing the process according to one or more of Claims 1 to 28, comprising a wire guide (23) and an ultrasonic generator (34), the ultrasonic generator (34) being connected to the wire guide (23) in such a way that the wire guide (23) is stimulated to execute ultrasonic vibrations in the direction of the longitudinal axis.

30. Device according to Claim 29,
characterised by
a vibrating punch (127) partially encompassing the cross-section of the wire of the wire conductor (113) and by an ultrasonic oscillator which brings about a vibrational loading of the vibrating punch (127) transverse to the longitudinal axis of the wire conductor (113) which is guided in a profiled end (126) of the vibrating punch (127).

31. Device according to Claim 30,
characterised in that
the ultrasonic instrument (125) is coupled to a wiring instrument.

32. Device according to Claim 30 or 31,
characterised in that
the ultrasonic oscillator of the ultrasonic instrument (125) serves simultaneously for ultrasonic loading of the wiring instrument.

33. Device according to Claim 32,
characterised in that
the ultrasonic oscillator is arranged in such a way that the axis of its effective direction is variable.

34. Device for the wiring of a wire-shaped conductor on a substrate in accordance with the process according to one or more of Claims 1 to 28, comprising a wire guide (94) and an ultrasonic generator (34), the wire guide (94) being arranged next to a vibrating punch (92) coupled to the ultrasonic generator (34) for the purpose of subjecting the wire conductor (20) to the action of mechanical vibrations induced by ultrasound and acting in the longitudinal direction of the vibrating punch.

35. Device according to Claim 34,
characterised by
a pivotal axis (100) coaxial with a vibrating-punch axis (97).

36. Device according to one or more of Claims 29 to 35,
characterised in that
the wire guide (23) comprises a wire-guidance capillary (37) which at least in the region of a wire-guide nozzle (30) extends in the wire guide (23) parallel to the longitudinal axis.

37. Device according to Claim 36,
characterised in that
the wire guide (23) comprises, spaced from the wire-guide nozzle (30), at least one wire-supply channel (38, 39) extending obliquely in relation to the longitudinal axis of the wire guide.

38. Device according to one or more of Claims 29 to 37,
characterised in that
the ultrasonic generator (34) is arranged coaxially with respect to the wire guide (23).

39. Device for implementing the process according to one or more of Claims 10 to 28 for the manufacture of a card module by making use of a device according to one or more of Claims 29 to 38, comprising
a yield supply station (65) for supplying a plurality of substrates (55) arranged in a yield (70),
a wiring station (66) with a plurality of wiring devices (22) arranged in a row transverse to the production direction,
an assembly station (67) with at least one assembly device (76) for equipping the individual substrates (55) with a chip unit (58) and
a connection station (68) with at least one connecting device (77) for connecting the chip units to an initial coil region (51) and to a final coil region (52) of the coils (50) which are formed on the substrates (55) by the wiring devices (22).

## Revendications

1. Procédé pour établir un contact avec un conducteur en forme de fil (113) disposé sur un substrat (111) lors de la fabrication d'une unité formant transpondeur, qui est disposée sur un substrat (111) et comporte une bobine de fil (112) et une unité formant puce (115), et selon lequel lors d'une première phase, on déplace le conducteur en forme de fil (113) d'une manière guidée au-dessus de la surface de raccordement (118, 119) ou d'une partie qui reçoit la surface de raccordement, et on le fixe par rapport à la surface de raccordement (118, 119) ou par rapport à la zone associée à la surface de raccordement, sur le substrat (111) et, lors d'une seconde phase, la liaison du conducteur en forme de fil (113) avec la surface de raccordement (118, 119) est exécutée au moyen d'un dispositif de liaison (125, 137).

2. Procédé selon la revendication 1, caractérisé en ce que pour la liaison du conducteur en forme de fil à la surface de raccordement, on utilise un dispositif à ultrasons.

3. Procédé selon la revendication 1, caractérisé en ce qu'aussi bien pour la liaison du conducteur en forme de fil à la surface de raccordement que pour le montage de la bobine de fil sur le substrat, on utilise un dispositif à ultrasons.

4. Procédé selon la revendication 1 ou 3, caractérisé en ce que le montage de la bobine de fil sur le substrat du conducteur en forme de fil s'effectue à l'aide d'un dispositif de pose agencé sous la forme d'un dispositif à ultrasons, de telle sorte qu'on applique des ultrasons au conducteur en forme de fil (20) dans une direction transversale par rapport au plan de pose (28), et qu'on superpose le déplacement transversal (24) du dispositif de pose (22), produit par l'application des ultrasons, au déplacement de pose (29) qui est exécuté dans le plan de pose (28).

5. Procédé selon une ou plusieurs des revendications précédentes, caractérisé en ce que le déplacement transversal (24) s'effectue le long d'un axe de déplacement transversal dont l'angle par rapport à l'axe du déplacement de pose (29) peut être modifié.

6. Procédé selon une ou plusieurs des revendications précédentes, caractérisé en ce qu'on modifie la fréquence des ultrasons et/ou l'angle entre l'axe du déplacement de pose (29) et l'axe de déplacement transversal (24) en fonction de la profondeur de pénétration désirée du conducteur en forme de fil (20).

7. Utilisation du procédé pour le montage d'une unité formant transpondeur, comportant une bobine et une unité formant puce, sur un substrat, selon une ou plusieurs des revendications précédentes, caractérisée en ce qu'on déplace d'une manière guidée, au-dessus d'un évidement (45) du substrat, une partie de fin (44) et une partie de départ (43) d'une bobine (41) formée lors de la pose sur le substrat (21).

8. Procédé selon la revendication 7, caractérisé en ce que l'application des ultrasons au conducteur en forme de fil (20) est interrompue dans la zone de l'évidement (45) du substrat.

9. Procédé selon une ou plusieurs des revendications précédentes, caractérisé en ce que pour franchir transversalement un tronçon de fil déjà posé dans la zone de franchissement transversal (57), on interrompt l'application des ultrasons au conducteur en forme de fil (20) et on guide le conducteur en forme de fil (20) dans un plan de franchissement transversal qui est distant du plan de pose (28).

10. Utilisation du procédé selon une ou plusieurs des revendications 4 à 9, pour la fabrication d'un module de carte (64) comportant un substrat (55), une bobine (50) posée sur le substrat et une unité formant puce (58) reliée à la bobine (50), et selon lequel lors d'une phase de pose, une bobine (50) possédant une partie de début (51) et une partie de fin (52) est formée sur le substrat (55) au moyen du dispositif de pose (22) et, lors d'une phase suivante de liaison, une liaison de la partie de début (51) et de la partie de fin (52) avec des surfaces de raccordement (59) de l'unité formant puce (58) est exécutée au moyen d'un dispositif de liaison (60).

11. Procédé selon la revendication 10, caractérisé en ce que le substrat est constitué par un matériau en forme de nappe, notamment du papier ou du carton, et que la liaison, qui intervient lors de la pose, est exécutée avec une couche d'adhésif disposée entre le conducteur en forme de fil (20) et la surface du substrat.

12. Procédé selon la revendication 10 ou 11, caractérisé en ce que la liaison de la partie de début (51) et de la partie de fin (52) de la bobine avec les surfaces de raccordement (59) de l'unité formant puce (58) est exécutée au moyen d'un procédé de thermocompression.

13. Procédé selon l'une des revendications 10 à 12, caractérisé en ce que
la fabrication d'une multiplicité de modules de cartes (64) s'effectue simultanément de telle sorte que, lors d'une phase d'amenée d'un dispositif de production (72) comportant une multiplicité de dispositifs de pose (22) et de dispositifs de liaison (60), une multiplicité de substrats (55) réunis par un flan (70) sont amenés, puis une multiplicité de bobines (50) sont formées simultanément, lors de la phase de pose, sur des substrats (55) disposés suivant une rangée,
ensuite lors de la phase de liaison, une multiplicité d'unités formant puces (58) sont reliées par l'intermédiaire de leurs surfaces de raccordement (59) aux bobines (50),
et enfin dans une phase de séparation, une séparation des modules de cartes (64) à partir de l'ensemble composite formant le flan est exécutée.

14. Utilisation du procédé selon une ou plusieurs des revendications 4 à 9, pour la fabrication d'une bobine de corps à symétrie de révolution, caractérisée en ce qu'on réalise la pose du conducteur en forme de fil (20) sur un substrat qui est agencé en tant que support d'enroulement (80) et tourne par rapport au dispositif de pose (22).

15. Procédé selon la revendication 14, caractérisé par la fabrication d'une bobine mobile d'une unité formant haut-parleur, qui est reliée d'un seul tenant à une membrane oscillante.

16. Utilisation du procédé selon l'une des revendications 4 à 9, caractérisée en ce qu'un nombre de dispositifs de pose (22), qui correspond au nombre des conducteurs désirés d'un câble est disposé transversalement par rapport à l'axe longitudinal d'un substrat en forme de bande plate (86) et qu'un déplacement relatif est exécuté entre le substrat (86) et les dispositifs de pose (22) dans la direction de l'axe longitudinal du support (86).

17. Procédé selon une ou plusieurs des revendications précédentes, caractérisé en ce qu'un prétraitement de la surface en aluminium de la surface de raccordement (118, 119) est exécuté avant la liaison du conducteur en forme de fil (113) à la surface de raccordement (118, 119).

18. Procédé selon la revendication 17, caractérisé en ce que pour le prétraitement, on réalise une élimination mécanique d'une couche d'oxyde disposée sur la surface d'aluminium, au moyen d'un traitement de la surface de raccordement (118, 119) par le dispositif à ultrasons (125).

19. Procédé selon la revendication 17, caractérisé en ce qu'en tant que prétraitement, on applique un procédé de nettoyage à la surface d'aluminium.

20. Procédé selon la revendication 19, caractérisé en ce qu'on utilise comme procédé de nettoyage un procédé de corrosion à sec, un procédé de corrosion par voie humide ou un traitement de la surface d'aluminium par laser.

21. Procédé selon la revendication 17, caractérisé en ce qu'en tant que prétraitement, on applique sur la surface d'aluminium une métallisation de contact multicouches (138, 139) comportant une couche de zincate disposée en tant que couche intermédiaire (140) sur la surface d'aluminium, et une couche de liaison (141, 142) prévue pour l'établissement du contact avec le conducteur en forme de fil (113).

22. Procédé selon la revendication 21, caractérisé en ce que la couche de liaison est réalisée sous la forme d'une couche comportant du nickel ou du palladium.

23. Procédé selon une ou plusieurs des revendications précédentes, caractérisé en ce que l'application d'oscillations au conducteur en forme de fil (113), produite par des ultrasons, s'effectue dans un plan sensiblement parallèle à la surface de raccordement (118, 119) et transversalement par rapport à l'axe longitudinal du conducteur en forme de fil (113).

24. Procédé selon la revendication 23, caractérisé en ce que l'application d'oscillations au conducteur en forme de fil (113), produite par des ultrasons, sert à éliminer par endroits un isolant du conducteur en forme de fil.

25. Procédé selon une ou plusieurs des revendications précédentes, caractérisé en ce que la fixation du conducteur en forme de fil (113) s'effectue sur une feuille de support en matière plastique, qui forme, conjointement avec le conducteur en forme de fil (113) et la puce (115), un insert de carte (110) pour fabriquer une carte à puce.

26. Procédé selon la revendication 25, caractérisé en ce que la fixation du conducteur en forme de fil (113) sur la feuille de support en matière plastique et la liaison du conducteur en forme de fil aux surfaces de raccordement de la puce (115) servent à réaliser un accrochage mécanique de la puce sur la feuille de support en matière plastique.

27. Procédé selon une ou plusieurs des revendications précédentes, caractérisé en ce que la fixation du conducteur en forme de fil (113) s'effectue par application avec un dispositif de pose possédant un dispositif à ultrasons.

28. Procédé selon la revendication 25, caractérisé en ce que le dispositif à ultrasons (121) servant à appliquer le conducteur en forme de fil (113) sur la feuille de support applique une charge oscillatoire au conducteur en forme de fil (113) transversalement par rapport à l'axe longitudinal du conducteur en forme de fil (113) et transversalement par rapport à la surface de la feuille de support, et le dispositif à ultrasons (125) servant à relier le conducteur en forme de fil (113) à la surface de raccordement (118, 119) applique une charge oscillatoire au conducteur en forme de fil (113) dans un plan sensiblement parallèle à la feuille de support et transversalement par rapport à l'axe longitudinal du conducteur en forme de fil (113).

29. Dispositif pour la mise en oeuvre du procédé selon une ou plusieurs des revendications 1 à 28, comportant un guide-fil (23) et un générateur d'ultrasons (34), le générateur d'ultrasons (34) étant relié au guide-fil (23) de telle sorte que le guide-fil (23) est activé pour la production d'oscillations ultrasoniques dans la direction de l'axe longitudinal.

30. Dispositif selon la revendication 29, caractérisé par un poinçon oscillant (127) entourant en partie la partie transversale du conducteur en forme de fil (113) et un oscillateur à ultrasons, qui soumet le poinçon oscillant (127) à une oscillation transversalement à l'axe longitudinal du conducteur en forme de fil (113) guidé dans une extrémité profilée (126) du poinçon oscillant (127).

31. Dispositif selon la revendication 30, caractérisé en ce que le dispositif à ultrasons (125) est couplé à un dispositif de pose.

32. Dispositif selon la revendication 30 ou 31, caractérisé en ce que l'oscillateur à ultrasons du dispositif à ultrasons (125) est utilisé simultanément pour l'application d'ultrasons au dispositif de pose.

33. Dispositif selon la revendication 32, caractérisé en ce que l'oscillateur à ultrasons est disposé de telle sorte que l'axe de sa direction d'action est modifiable.

34. Dispositif pour la pose d'un conducteur en forme de fil sur un substrat conformément au procédé selon une ou plusieurs des revendications 1 à 28, comportant un guide-fil (94) et un générateur d'ultrasons (34), et dans lequel le guide-fil (94) est disposé à côté d'un poinçon oscillant (92), qui est couplé au générateur d'ultrasons (34) et sert à appliquer au conducteur en forme de fil (20) des oscillations mécaniques, induites par ultrasons et agissant dans la direction longitudinale du poinçon oscillant.

35. Dispositif selon la revendication 34, caractérisé par un axe de pivotement (100) qui est coaxial à un axe (97) du poinçon oscillant.

36. Dispositif selon une ou plusieurs des revendications 29 à 35, caractérisé en ce que le guide-fil (23) possède un capillaire (37) de guidage du fil, qui s'étend au moins dans la zone d'un embout de guide-fil (30) parallèlement à l'axe longitudinal à l'intérieur du guide-fil (23).

37. Dispositif selon la revendication 36, caractérisé en ce que le guide-fil (23) comporte, à distance de son embout (30), au moins un canal (38, 39) d'amenée du fil, qui s'étend obliquement par rapport à l'axe longitudinal du guide-fil.

38. Dispositif selon une ou plusieurs des revendications 29 à 37, caractérisé en ce que le générateur d'ultrasons (34) est disposé coaxialement par rapport au guide-fil (23).

39. Dispositif pour la mise en oeuvre du procédé pour fabriquer un module de carte selon une ou plusieurs des revendications 10 à 28, moyennant l'utilisation d'un dispositif selon une ou plusieurs des revendications 29 à 38, comportant :
un poste (65) d'amenée d'un flan, qui sert à amener une multiplicité de substrats (55) disposés dans un flan (70),
un poste de pose (66) comportant une multiplicité de dispositifs de pose (22) disposés suivant une rangée transversalement par rapport à la direction de fabrication,
un poste d'équipement (67) comportant au moins un dispositif d'équipement (76) servant à équiper les substrats individuels (55) avec une unité formant puce (58), et
un poste de liaison (68) comportant au moins un dispositif de liaison (77) servant à relier les unités formant puces à une partie de début (51) et à une partie de fin (52) des bobines (50) formées sur les substrats (55) par les dispositifs de pose (22).
